# EUROPEAN PATENT APPLICATION

(11) **EP 4 632 962 A1**
(43) Date of publication of application: **15.10.2025**
(21) Application number: 23909339.6
(22) Date of filing: 12.09.2023
(51) Int. Cl.: H01R 13/40

(54) **BACKPLANE SYSTEM AND PREPARATION METHOD THEREFOR, AND CABINET**

(30) Priority: 30.12.2022 CN 202211736745
(71) Applicant: xFusion Digital Technologies Co., Ltd., Zhengzhou, Henan 450000 (CN)
(72) Inventor: DENG, Zhigao, Zhengzhou, Henan 450000 (CN); DAN, Yuping, Zhengzhou, Henan 450000 (CN); LI, Wenliang, Zhengzhou, Henan 450000 (CN); CHEN, Gang, Zhengzhou, Henan 450000 (CN); YANG, Chengjian, Zhengzhou, Henan 450000 (CN)
(74) Representative: MERH-IP Matias Erny Reichl Hoffmann Patentanwälte PartG mbB
(86) International application number: PCT/CN2023/118246
(87) International publication number: WO 2024/139402

(57) **Abstract**

The present application provides a backplane system, a fabrication method therefor and a cabinet, where the backplane system is configured to be electrically connected to a plurality of electronic modules, and includes a cable box, a plurality of terminal connecting members, and a plurality of first cables, where the cable box is provided with an accommodating cavity, each terminal connecting member includes a circuit board, a plurality of first conductive terminals and a plurality of second conductive terminals, the circuit board includes a first end portion and a second end portion, the circuit board is mounted in the cable box, the first end portion protrudes relative to the cable box, the second end portion is located in the accommodating cavity, the plurality of first conductive terminals are mounted on the first end portion and spaced apart from each other, and are configured to be electrically connected to one of the electronic modules, the plurality of second conductive terminals are mounted on the second end portion and spaced apart from each other, and the plurality of first conductive terminals are respectively electrically connected to the plurality of second conductive terminals, and each first cable is located in the accommodating cavity, and electrically connected between second conductive terminals of two terminal connecting members. The backplane system is used to reduce a quantity of connectors used, which is beneficial to increasing a signal bandwidth between the electronic modules.

## Description

This application claims priority to Chinese Patent Application No. 202211736745.5, filed with the China National Intellectual Property Administration on December 30, 2022, and entitled "BACKPLANE SYSTEM, FABRICATION METHOD THEREFOR, AND CABINET", which is incorporated herein by reference in its entirety.

### TECHNICAL FIELD

The present application relates to the field of electronic product technology, and in particular to a backplane system, a fabrication system therefor and a cabinet.

### BACKGROUND

As the performance of computing or communication systems improves, a bandwidth required for interconnection is increasing, the physical bandwidth of a link imposes an increasingly significant influence on the signal bandwidth interconnected between electronic modules. Especially for large and complex computing or communication systems, signal interaction between a plurality of electronic modules needs to be achieved through the backplane system. In related art, male connectors and female connectors are commonly used in conjunction to establish an electrical connection between the electronic modules and the backplane system. When the male and female connectors are assembled on the circuit board, their own electrical performance SI (signal integrity) losses will exist. Therefore, the mating of male and female connectors may introduce insertion losses in high-speed links. Communication among the plurality of electronic modules achieved by using an existing backplane system requires cooperation of a plurality of groups of male and female connectors, resulting in more signal transmission losses.

### SUMMARY

Embodiments of the present application aim to provide a backplane system, a fabrication method therefor and a cabinet. In the backplane system, a terminal connecting member is electrically connected to an electronic module, which reduces a quantity of connectors used, and facilitates reducing a signal transmission loss, thereby enhancing a signal bandwidth interconnected between electronic modules.

Embodiments of the present application provide a backplane system, where the backplane system is configured to be electrically connected to a plurality of electronic modules, and the backplane system includes a cable box, a plurality of terminal connecting members, and a plurality of first cables, where the cable box is provided with an accommodating cavity, each terminal connecting member includes a circuit board, a plurality of first conductive terminals and a plurality of second conductive terminals, the circuit board includes a first end portion and a second end portion which are spaced apart from each other, the circuit board is mounted in the cable box, the first end portion protrudes relative to the cable box, the second end portion is located in the accommodating cavity, the plurality of first conductive terminals are mounted on the first end portion and spaced apart from each other, and are configured to be electrically connected to one of the electronic modules, the plurality of second conductive terminals are mounted on the second end portion and spaced apart from each other, the plurality of first conductive terminals are respectively electrically connected to the plurality of second conductive terminals, and each first cable is located in the accommodating cavity, and electrically connected between second conductive terminals of two terminal connecting members.

In the backplane system provided in the embodiments of the present application, the first cable is electrically connected among the second conductive terminals of the plurality of terminal connecting members, to achieve an electrical connection among the plurality of terminal connecting members. Meanwhile, the first conductive terminals of the plurality of terminal connecting members are respectively electrically connected to the plurality of electronic modules, to achieve an electrical connection between the backplane system and the plurality of electronic modules, thereby enabling signal interaction among the plurality of electronic modules through the backplane system. In the backplane system provided in the embodiments of the present application, the terminal connecting member is electrically connected to the electronic modules, which saves a connector mounted on a conventional backplane system, reduces a quantity of connectors used, and is conducive to reducing the signal transmission loss, thereby improving a signal bandwidth interconnected among the electronic modules.

In a possible implementation, the first end portion and the second end portion are disposed opposite to each other.

In a possible implementation, the first end portion includes a first mounting face and a second mounting face, the first mounting face and the second mounting face are disposed facing away from each other along a thickness direction of the first end portion, and the plurality of first conductive terminals are mounted on at least one of the first mounting face and the second mounting face.

In a possible implementation, each terminal connecting member includes a first face terminal group and a second face terminal group, the first face terminal group and the second face terminal group each includes the plurality of first conductive terminals, the plurality of first conductive terminals of the first face terminal group are mounted on the first mounting face, and the plurality of first conductive terminals of the second face terminal group are mounted on the second mounting face. Compared with configuring the first conductive terminals only on the first mounting face or only on the second mounting face, the plurality of first conductive terminals are respectively mounted on the first mounting face and the second mounting face, which may increase a mounting density of the first conductive terminals and an outgoing line density of the first cables connected to the first conductive terminals, thereby meeting a high outgoing line density requirement of a large and complex computing or communication system.

In a possible implementation, the first face terminal group includes at least one row of first conductive terminals, and/or, the second face terminal group includes at least one row of first conductive terminals; and
each row of first conductive terminals includes a plurality of first conductive terminals.

In a possible implementation, the first face terminal group includes a plurality of rows of first conductive terminals;
the first end portion includes a plurality of mounting portions, the plurality of mounting portions are sequentially arranged along a direction from the first end portion to the second end portion, among any two adjacent mounting portions, a thickness of a mounting portion away from the second end portion is less than a thickness of a mounting portion close to the second end portion, and the plurality of rows of first conductive terminals of the first face terminal group are respectively mounted on the plurality of mounting portions. When the terminal connecting member is processed, Overhang (nickel or gold overhang) may occur on a first conductive terminal mounted on an end face close to the first end portion in the first face terminal group. When the plurality of first conductive terminals of the terminal connecting member are plugged into and mated with the connector of the electronic module, due to a small mating gap between the terminal connecting member and the connector, overhang or detachment may occur on the first conductive terminals during plug-in and plug-out of the terminal connecting member, thereby posing a short circuit risk between adjacent first conductive terminals in the first face terminal group. Thicknesses of the plurality of mounting portions in the first end portion are disposed, so that the plurality of rows of first conductive terminals in the first terminal group are staggered in height, which increases a mating gap between the first conductive terminal on the end face close to the first end portion in the first face terminal group, and the connector. This avoids the problem of overhang or detachment caused by plug-in and plug-out of the terminal connecting member, thereby solving the short circuit risk in the first conductive terminals of the terminal connecting member.

In a possible implementation, the second face terminal group includes a plurality of rows of first conductive terminals, and the plurality of rows of first conductive terminals of the second face terminal group are respectively mounted on the plurality of mounting portions.

In a possible implementation, the second end portion includes a first fixing face and a second fixing face, the first fixing face and the second fixing face are disposed facing away from each other along a thickness direction of the second end portion, each terminal connecting member includes a third face terminal group and a fourth face terminal group, the third face terminal group and the fourth face terminal group each includes a plurality of second conductive terminals, the plurality of second conductive terminals of the third face terminal group are mounted on the first mounting face, and the plurality of second conductive terminals of the fourth face terminal group are mounted on the second mounting face.

In a possible implementation, each terminal connecting member further includes a first insert and a plurality of second cables, the first insert includes a first carrier part and a plurality of third conductive terminals, the first carrier part is mounted on the circuit board and disposed between the first face terminal group and the third face terminal group, and the plurality of third conductive terminals are mounted on a surface of the first carrier part facing away from the circuit board and spaced apart from each other;
each third conductive terminal includes a first end and a second end which are disposed facing away from each other, the first end faces the first conductive terminal, and is configured to be electrically connected to the electronic module, and the second end faces the second conductive terminal; and
each second cable is located in the accommodating cavity, and electrically connected between second ends of the two terminal connecting members, or, electrically connected between a second conductive terminal of one terminal connecting member and a second end of one terminal connecting member. The first insert is disposed, so that the formed terminal connecting member presents a three-dimensional structure. The plurality of third conductive terminals of the first insert can ensure a mounting density of the conductive terminals, thereby ensuring a high cable outgoing line density. On the other hand, the first end and the second end of each of the third conductive terminals are respectively electrically connected to the electronic modules and the second cable, achieving signal interaction among the plurality of electronic modules, without a need for via formation and layer transition in the circuit board, thereby saving a fabricating process.

In a possible implementation, there are a plurality of first inserts, and the plurality of first inserts are stacked and mounted on the circuit board.

In a possible implementation, between any two adjacent first inserts, a first end and a second end of a first insert close to the circuit board are both exposed relative to the other first insert.

In a possible implementation, each terminal connecting member further includes a second insert and a plurality of third cables, the second insert includes a second carrier part and a plurality of fourth conductive terminals, the second carrier part is mounted on the circuit board and disposed between the second face terminal group and the fourth face terminal group, and the plurality of fourth conductive terminals are mounted on a surface of the second carrier part facing away from the circuit board and spaced apart from each other;
each fourth conductive terminal includes a third end and a fourth end which are disposed facing away from each other, the third end faces the first conductive terminal, and is configured to be electrically connected to the electronic module, and the fourth end faces the second conductive terminal; and
each third cable is located in the accommodating cavity, and electrically connected between fourth ends of the two terminal connecting members, or, electrically connected between a second conductive terminal of one terminal connecting member and a fourth end connected to one terminal.

In a possible implementation, there are a plurality of second inserts, and the plurality of second inserts are stacked and mounted on the circuit board.

In a possible implementation, between any two adjacent second inserts, a third end and a fourth end of a second insert close to the circuit board are both exposed relative to the other second insert.

In a possible implementation, the backplane system further includes a plurality of fixing members, where the plurality of fixing members are mounted in the cable box, each fixing member is provided with at least one fixing slot, each fixing slot penetrates the fixing member along a width direction of the fixing member, a circuit board of each terminal connecting member is mounted in one fixing slot, and the first end portion and the second end portion both protrude relative to the fixing member.

In a possible implementation, a stopper is provided on a side wall of each fixing slot, and the circuit board of each terminal connecting member includes a main body portion, the main body portion is provided with a snap-fit slot, the snap-fit slot penetrates the main body portion along a thickness direction of the main body portion and penetrates an edge of the main body portion, the main body portion is mounted in the fixing slot, and the snap-fit slot snap-fits with the stopper.

In a possible implementation, the stopper includes a first stopper and a second stopper, the first stopper and the second stopper are respectively provided on two oppositely disposed side walls of the fixing slot, the snap-fit slot includes a first snap-fit slot and a second snap-fit slot, the first snap-fit slot and the second snap-fit slot are respectively provided at opposite ends of the main body portion, the first snap-fit slot snap-fits with the first stopper, the second snap-fit slot snap-fits with the second stopper, and a quantity of the first snap-fit slots is different from a quantity of the second snap-fit slots, achieving a foolproof effect and ensuring a precise assembly between the terminal connecting member and the fixing member.

In a possible implementation, the fixing member includes a first fixing portion and a second fixing portion, where along the thickness direction of the fixing member, the first fixing portion is covered on the second fixing portion, and encloses a fixing slot with the second fixing portion.

In a possible implementation, each fixing member includes a fixing part and a plurality of guide parts, the fixing part is provided with the fixing slot, the fixing slot penetrates the fixing part along a width direction of the fixing part, and the plurality of guide parts are all mounted on a surface of the fixing part toward the first end portion, all extend along a direction facing away from the fixing part, and are disposed around the fixing slot. The guide part is disposed, to enable the terminal connecting member to be electrically connected to the electronic module, thereby facilitating guiding the backplane system to be electrically connected to the electronic module.

In a possible implementation, the cable box is provided with a plurality of mounting slots, the plurality of mounting slots are spaced apart from each other, an opening of each mounting slot is located on a surface of the cable box facing away from the accommodating cavity, and is in communication with the accommodating cavity, and each fixing member is mounted in one mounting slot.

In a possible implementation, the backplane system further includes a plurality of groups of carrying members, the plurality of groups of carrying members are mounted on an inner wall of the accommodating cavity, each group of carrying members includes a plurality of carrying members, the plurality of carrying members of each group of carrying members partially block one mounting slot, and each fixing member abuts against the plurality of carrying members of each group of carrying members.

In a possible implementation, the backplane system further includes a plurality of groups of positioning members, where each group of positioning members includes a plurality of positioning members, the plurality of positioning members are all mounted on a surface of the cable box facing away from the accommodating cavity, all extend along a direction facing away from the accommodating cavity, and are disposed around the terminal connecting member, and the plurality of positioning members of each group of positioning members are configured to position one of the electronic modules.

Embodiments of the present application further provide a cabinet, including a cabinet body, a plurality of electronic modules, and the above backplane system, where the plurality of electronic modules and the backplane system are all mounted inside the cabinet body, and each electronic module is electrically connected to the plurality of first conductive terminals of the terminal connecting member.

In a possible implementation, each electronic module includes a housing, at least one connector and a plurality of electronic components, the at least one connector is mounted inside the housing, the housing is provided with at least one through slot, the at least one through slot penetrates the housing along a thickness direction of the housing, and each connector is exposed relative to the through slot, and is electrically connected to the plurality of first conductive terminals of the terminal connecting member.

In a possible implementation, each electronic module further includes at least one floating member, each floating member is mounted inside the housing, and each connector is mounted inside one floating member and movable relative to the housing along a direction facing away from the backplane system, which effectively avoids the over-plugging problem of the terminal connecting member and the electronic module, thereby achieving an anti-over-plugging effect.

In a possible implementation, some of the terminal connecting members are mounted on one side of the cable box, some of the terminal connecting members are mounted on another side of the cable box, some of the electronic modules are located on one side of the cable box, and some of the electronic modules are located on another side of the cable box. This arrangement facilitates mounting or removing the electronic modules from both sides of the cabinet, thereby facilitating maintaining the electronic modules.

Embodiments of the present application further provide a fabrication method for a backplane system, including steps of fabricating a terminal connecting member, where the steps include:
taking a circuit board, where the circuit board includes a first end portion and a second end portion which are spaced apart from each other, fabricating a plurality of first conductive terminals at the first end portion, and fabricating a plurality of second conductive terminals at the second end portion;
fabricating an insert, where the insert includes a carrier part and a plurality of conductive terminals, and the plurality of conductive terminals are mounted on a same side surface of the carrier part; and
mounting at least one insert between the plurality of first conductive terminals and the plurality of second conductive terminals, where the carrier part of the insert faces the circuit board.

In a possible implementation, the plurality of first conductive terminals include a first face terminal group and a second face terminal group, a plurality of first conductive terminals of the first face terminal group and a plurality of first conductive terminals of the second face terminal group are respectively mounted on two surfaces of the first end portion which are disposed facing away from each other, the plurality of second conductive terminals include a third face terminal group and a fourth face terminal group, a plurality of second conductive terminals of the third face terminal group and a plurality of second conductive terminals of the fourth side terminal group are respectively mounted on two surfaces of the second end portion which are disposed facing away from each other, and the third face terminal group and the first face terminal group are located on a same side of the circuit board, and the fourth face terminal group and the second face terminal group are located on a same side of the circuit board; and
there are a plurality of inserts, at least one of the plurality of inserts is mounted on the circuit board, and located between the first face terminal group and the third face terminal group, and at least one of the plurality of inserts is mounted on the circuit board, and located between the second face terminal group and the fourth face terminal group.

### BRIEF DESCRIPTION OF DRAWINGS

In order to more clearly illustrate technical solutions in embodiments of the present application or in the related art, accompany drawings used in the embodiments of the present application or in the related art will be described briefly. Apparently, the drawings in the following description are only some embodiments of the present application, and other drawings may be obtained based on these drawings without creative effort for those skilled in the art.
FIG. 1 is a structural diagram of a cabinet according to a first embodiment of the present application;
FIG. 2 is a schematic main view of an electrical connection structure formed by a backplane system and a plurality of electronic modules in the cabinet shown in FIG. 1;
FIG. 3 is a cross-sectional structural diagram of the electrical connection structure shown in FIG. 2 in some application scenarios;
FIG. 4 is a structural diagram of the backplane system in the electronic connection structure shown in FIG. 2;
FIG. 5 is a partial enlarged view of the backplane system shown in FIG. 4 at A;
FIG. 6 is a structural diagram of an electrical connection between the backplane system and the electronic modules shown in FIG. 4;
FIG. 7 is a structural diagram of a cable box in the backplane system shown in FIG. 4;
FIG. 8 is a partial structural diagram of a cover body in the cable box shown in FIG. 7 after being assembled with a positioning member and a carrying member from another perspective;
FIG. 9 is an exploded structural diagram of a fixing member in the backplane system shown in FIG. 4;
FIG. 10 is a structural diagram of a terminal connecting member in the backplane system shown in FIG. 4;
FIG. 11 is a structural diagram of the terminal connecting member shown in FIG. 10 from another perspective;
FIG. 12 is a schematic diagram of an assembly structure of a terminal connecting member, a first cable and a fixing member in the backplane system shown in FIG. 4;
FIG. 13 is a partial structural diagram of the electronic module in the electronic connection structure shown in FIG. 2;
FIG. 14 is an exploded structural diagram of a partial structure of the electronic module shown in FIG. 13;
FIG. 15 is an exploded structural diagram of a floating member of a connector assembly in the partial structure of the electronic module shown in FIG. 14;
FIG. 16 is an exploded structural diagram of a connector and a fixing housing of a connector assembly in the partial structure of the electronic module shown in FIG. 14;
FIG. 17 is a schematic diagram of an assembly structure of the connector and the fixing housing shown in FIG. 16;
FIG. 18 is a top view structural diagram of a terminal connecting member according to a second embodiment of the present application;
FIG. 19 is a cross-sectional structural diagram of a terminal connecting member according to a third embodiment of the present application;
FIG. 20 is a cross-sectional structural diagram of a terminal connecting member according to a fourth embodiment of the present application;
FIG. 21 is a top view structural diagram of the terminal connecting member shown in FIG. 20;
FIG. 22 is a structural diagram of a process flow of the terminal connecting member shown in FIG. 20;
FIG. 23 is a cross-sectional structural diagram of a terminal connecting member according to a fifth embodiment of the present application;
FIG. 24 is a side view structural diagram of a cabinet according to a sixth embodiment of the present application; and
FIG. 25 is a cross-sectional structural diagram of an electrical connection structure between a plurality of electronic modules and a backplane system in the cabinet shown in FIG. 24.

### DESCRIPTION OF EMBODIMENTS

The following clearly and completely describes technical solutions in embodiments of the present application in combination with accompanying drawings of the embodiments of the present application. Apparently, the described embodiments are some but not all of the embodiments of the present application. All other embodiments obtained by those skilled in the art without creative efforts based on the embodiments of the present application fall within the protection scope of the present application.

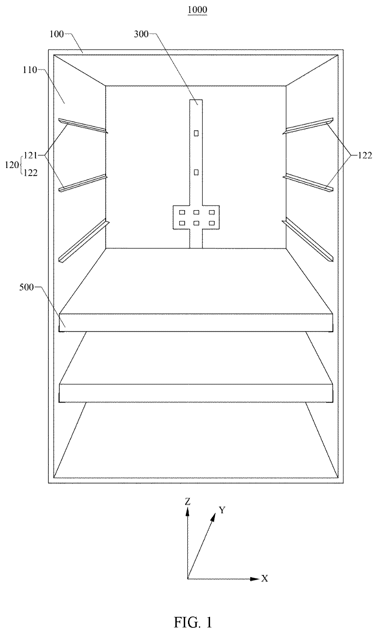

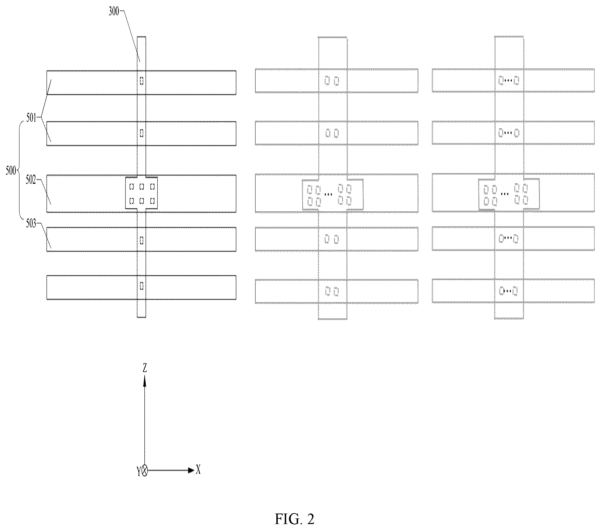

As shown in FIG. 1 and FIG. 2, FIG. 1 is a structural diagram of a cabinet 1000 according to a first embodiment of the present application, and FIG. 2 is a schematic main view of an electrical connection structure formed by a backplane system 300 and a plurality of electronic modules 500 in the cabinet 1000 shown in FIG. 1.

For ease of description, a length direction of the cabinet 1000 shown in FIG. 1 is defined as an X-axis direction, a width direction as a Y-axis direction, and a height direction as a Z-axis direction, and the X-axis direction, Y-axis direction, and Z-axis direction are mutually perpendicular to each other in pairs. The orientation terms such as "front" and "back" used in the description of the cabinet 1000 in the embodiments of the present application, are based on orientations shown in FIG. 1 of the description, where a negative Y-axis direction is defined as the "front" and a positive Y-axis direction as the "back". These terms do not construe a limitation of actual application scenarios of the cabinet 1000. The cabinet 1000 may be a rack-scale server, cabinet switch, and the like. In the embodiments of the present application, the cabinet 1000 is described by taking the rack-scale server for example.

The cabinet 1000 includes a cabinet body 100, a backplane system 300, and a plurality of electronic modules 500. The backplane system 300 and the plurality of electronic modules 500 are all mounted inside the cabinet body 100. In the embodiment, the plurality of electronic modules 500 are all located on a same side of the backplane system 300, and are electrically connected to the backplane system 300. The backplane system 300 forms a communication channel among the plurality of electronic modules 500, enabling signal interaction among the plurality of electronic modules 500. The electronic module 500 may be an electronic device, or an electronic component in the electronic device such as a hard disk. In the embodiment, the electronic module 500 is described by taking the electronic device for example.

Specifically, the cabinet body 100 is provided with a plurality of groups of slots 120. The plurality of groups of slots 120 are spaced apart along the Z-axis direction. Each group of slots 120 includes a first slot 121 and a second slot 122, and the first slot 121 and the second slot 122 extend along the Y-axis direction, and are spaced apart and disposed opposite to each other along the X-axis direction. In the embodiment, the cabinet body 100 includes two side plates 110, the two side plates 110 are spaced apart and disposed opposite to each other along the X-axis direction, and the first slot 121 and the second slot 122 are respectively mounted on the two side plates 110.

Each electronic module 500 is mounted in a group of slots 120, and is mounted into the first slot 121 and the second slot 122 in the group of slots 120. Each electronic module 500 is electrically connected to the backplane system 300, enabling the signal interaction among the plurality of electronic modules 500 through the backplane system 300. Among the plurality of electronic modules 500, some of the electronic modules 500 may be computing nodes 501, some of the electronic modules 500 may be switching modules 502, and some of the electronic modules 500 may be management modules 503. The computing node 501, the switching module 502, and the management module 503 are all electrically connected to the backplane system 300, enabling signal interaction among the computing node 501, the switching module 502, and the management module 503 through the backplane system 300. For example, the computing node 501 may be a computing node module that is equipped with components such as a CPU, memory, drive and the like and is responsible for a service computing function or achieves other functions. The computing node 501 may be specifically a server service processing subcard or other service processing module subcards. The switching module 502 may achieve data switching among the computing nodes 501, and its switching protocol may be Ethernet or Infiniband (infinite bandwidth technology). The management module 503 mainly manages each computing node 501 in a server, and management information includes manufacturer information, hardware state information, temperature information and the like.

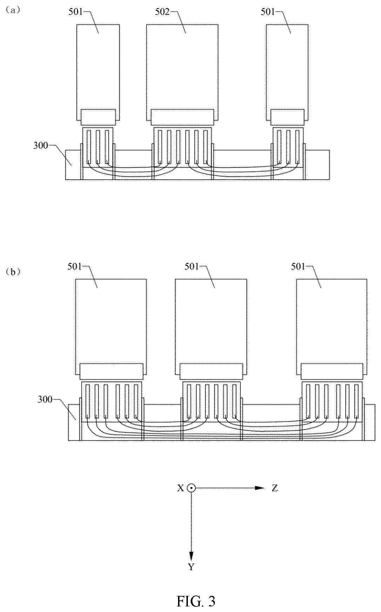

As shown in FIG. 3, FIG. 3 is a cross-sectional structural diagram of the electrical connection structure shown in FIG. 2 in some application scenarios. (a) in FIG. 3 shows a cross-sectional structural diagram of an electrical connection structure between the switching module 502 and a plurality of computing nodes 501, and (b) in FIG. 3 shows a cross-sectional structural diagram of an electrical connection structure among the plurality of computing nodes 501. It should be noted that in the electrical connection structure shown in FIG. 3, the switching module 502 and the computing node 501 are in a state before being plugged into the backplane system 300.

As shown in (a) of FIG. 3, in some application scenarios, the plurality of computing nodes 501 and the switching module 502 are electrically connected to the backplane system 300 to enable signal interaction between the computing nodes 501 and the switching module 502. It is understandable that the switching module 502 may also be replaced by the management module 503 to achieve signal interaction between the computing node 501 and the management module 503. As shown in (b) of FIG. 3, in some application scenarios, the plurality of computing nodes 501 are electrically connected to the backplane system 300 to achieve signal interaction among the plurality of computing nodes 501.

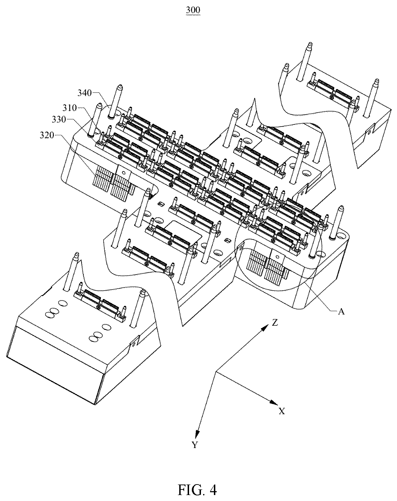

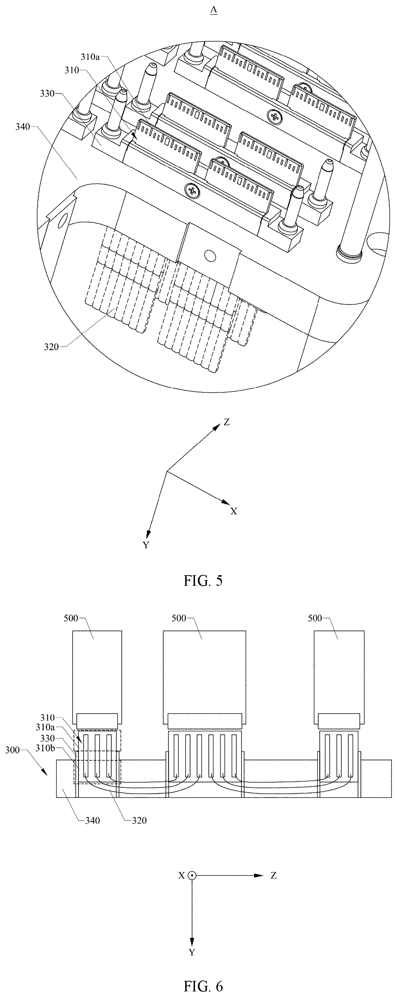

As shown in FIG. 4, FIG. 5, and FIG. 6, FIG. 4 is a structural diagram of the backplane system 300 in the electronic connection structure shown in FIG. 2, FIG. 5 is a partial enlarged view of the backplane system 300 shown in FIG. 4 at A, and FIG. 6 is a structural diagram of an electrical connection between the backplane system 300 and the electronic modules 500 shown in FIG. 4. In the structure shown in FIG. 6, the electronic modules 500 are in a state before being plugged into the backplane system 300.

The backplane system 300 includes a cable box 340, a plurality of terminal connecting members 310, a plurality of first cables 320, and a plurality of fixing members 330. The plurality of terminal connecting members 310 are all mounted in the cable box 340, and are spaced apart from each other. The plurality of fixing members 330 are all mounted on the cable box 340, and each fixing member 330 mounts at least one terminal connecting member 310 in the cable box 340. Each first cable 320 is accommodated inside the cable box 340, and is electrically connected between the two terminal connecting members 310.

Specifically, each terminal connecting member 310 includes a connecting end portion 310b and a plug-in end portion 310a. The connecting end portion 310b and the plug-in end portion 310a are disposed facing away from each other, and are electrically connected to each other. The connecting end portion 310b of each terminal connecting member 310 is located inside the cable box 340, and is electrically connected to connecting end portions 310b of other terminal connecting members 310 by the first cable 320, thereby achieving an electrical connection among the plurality of terminal connecting members 310. The plug-in end portion 310a protrudes relative to the fixing member 330, and is electrically connected to one electronic module 500, achieving an electrical connection between the terminal connecting member 310 and the electronic module 500. In this way, the plurality of electronic modules 500 may be electrically connected to each other by the plurality of terminal connecting members 310, further enabling signal interaction among the plurality of electronic modules 500 through the backplane system 300.

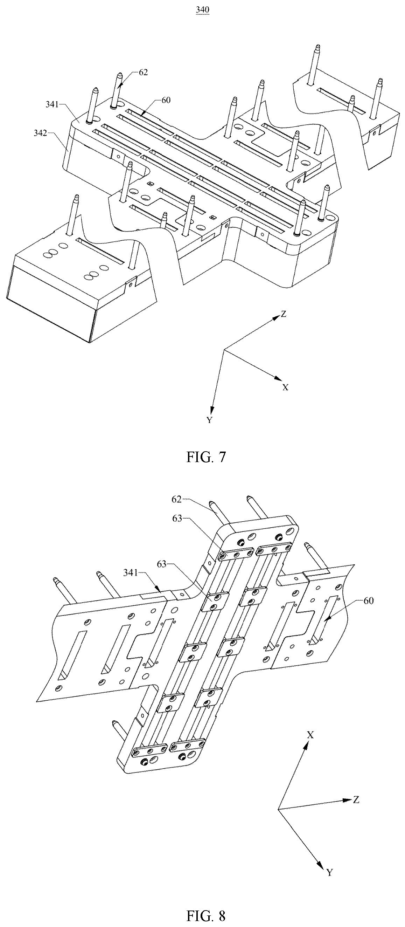

As shown in FIG. 7 and FIG. 8, FIG. 7 is a structural diagram of a cable box 340 in the backplane system 300 shown in FIG. 4, and FIG. 8 is a partial structural diagram of a cover body 341 in the cable box 340 shown in FIG. 7 after being assembled with a positioning member 62 and a carrying member 63 from another perspective. Some of the carrying members 63 are omitted in FIG. 8.

The cable box 340 is provided with an accommodating cavity (not shown in FIG. 7) and a plurality of mounting slots 60. The accommodating cavity is configured for accommodating the first cable 320. The plurality of mounting slots 60 are spaced apart, and each mounting slot 60 is configured for one fixing member 330 to be mounted therein. An opening of each mounting slot 60 is located on a surface of the cable box 340 toward the negative Y-axis direction, and is in communication with the accommodation cavity.

Specifically, the cable box 340 includes a cover body 341 and a box body 342. The cover body 341 is covered on the box body 342, and encloses the accommodating cavity with the box body 342. A surface of the cover body 341 toward the accommodating cavity is a portion of an inner wall of the accommodating cavity. The cover body 341 is provided with a mounting slot 60, and the mounting slot 60 penetrates the cover body 341 along a thickness direction of the cover body 341.

The backplane system 300 further includes a plurality of groups of positioning members 62 and a plurality of groups of carrying members 63. The plurality of groups of positioning members 62 and the plurality of groups of carrying members 63 are mounted in the cable box 340. The plurality of positioning members 62 of each group of positioning members 62 are configured to position one electronic module 500. Specifically, each group of positioning members 62 includes the plurality of positioning members 62, the plurality of positioning members 62 are all mounted on a surface of the cable box 340 facing away from the accommodating cavity, and all extend along a direction facing away from the accommodating cavity (the negative Y-axis direction in FIG. 8), and are disposed around the mounting slot 60. In the embodiment, the plurality of positioning members 62 of each group of positioning members 62 are all mounted on the surface of the cover body 341 facing away from the accommodating cavity, and are all located on both sides of an opening of the mounting slot 60 along the X-axis direction, and are spaced apart from the opening of the mounting slot 60. The plurality of groups of carrying members 63 are mounted on an inner wall of the accommodating cavity of the cable box 340. Each group of carriers 63 includes a plurality of carrying members 63, and the plurality of carrying members 63 of each group of carrying members 63 partially block one mounting slot 60. In the embodiment, the plurality of groups of carrying members 63 are all mounted on a surface of the cover body 341 toward the accommodating cavity. The plurality of carrying members 63 of each group of carrying members 63 block two end portions of one mounting slot 60 along the X-axis direction.

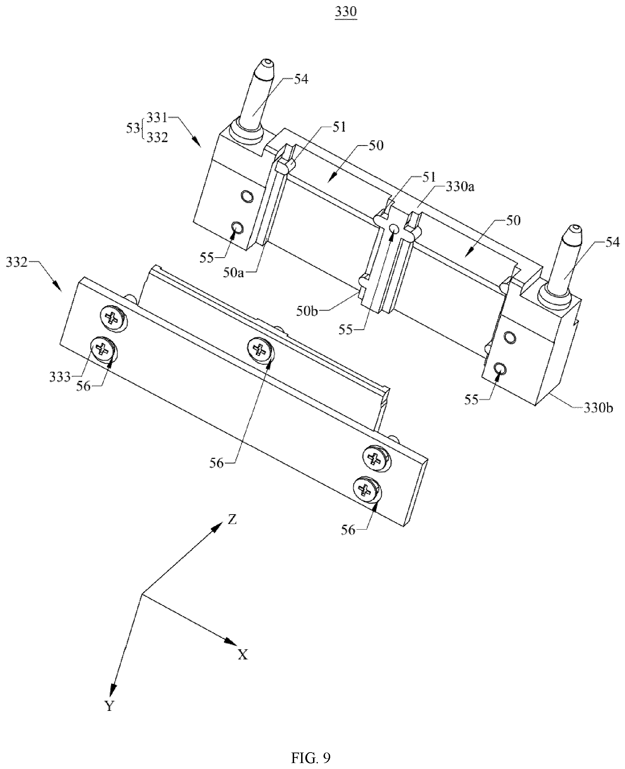

As shown in FIG. 9, FIG. 9 is an exploded structural diagram of the fixing member 330 in the backplane system 300 shown in FIG. 4. A length direction of the fixing member 330 is defined as an X-axis direction, a width direction as a Y-axis direction, and a height direction as a Z-axis direction.

Each fixing member 330 is provided with at least one fixing slot 50. The fixing slot 50 penetrates the fixing member 330 along the Y-axis direction, and is configured for the terminal connecting member 310 to be mounted therein. In the embodiment, one fixing member 330 is provided with two fixing slots 50, and the two fixing slots 50 are spaced apart along the X-axis direction. Each fixing slot 50 is configured for one terminal connecting member 310 to be mounted therein. A plurality of stoppers 51 are provided on a side wall of each fixing slot 50, and each stopper 51 protrudes toward the fixing slot 50 relative to the side wall of the fixing slot 50. The side wall of each fixing slot 50 includes a first side wall 50a and a second side wall 50b that are disposed opposite to each other, and the first side wall 50a and the second side wall 50b extend along the Y-axis direction and are disposed opposite to each other along the X-axis direction. The plurality of stoppers 51 includes a first stopper and a second stopper, the first stopper is provided on the first side wall 50a of each fixing slot 50, and the second stopper is provided on the second side wall 50b of each fixing slot 50. In the embodiment, there are one first stopper and two second stoppers. In other embodiments, there may be two, three or more first stoppers, and there may be one, three or more second stoppers. A quantity of the first stoppers and a quantity of the second stoppers are not limited in the embodiments of the present application.

Each fixing member 330 includes a fixing part 53 and a plurality of guide parts 54. The fixing part 53 includes a first surface 330a and a second surface 330b, and the first surface 330a and the second surface 330b are disposed facing away from each other along the Y-axis direction. The fixing part 53 is provided with a fixing slot 50, and the fixing slot 50 penetrates the first surface 330a and the second surface 330b. The plurality of guide parts 54 are provided on the first surface 330a of the fixing part 53, extend along a direction facing away from the first surface 330a, and are disposed around the fixing slot 50. In the embodiment, there are two guide parts 54. The two guide parts 54 are located on both sides of an opening of the fixing slot 50, and are spaced apart from the opening of the fixing slot 50.

In the embodiment, the fixing part 53 includes a first fixing portion 331 and a second fixing portion 332. The first fixing portion 331 and the second fixing portion 332 may be covered along the Z-axis direction and fixedly connected to form the fixing slot 50. The first fixing portion 331 includes a first surface and a second surface that are disposed facing away from each other along the Y-axis direction. The first surface of the first fixing portion 331 is a portion of the first surface 330a of the fixing part 53, and the second surface of the first fixing portion 331 is a portion of the second surface 330b of the fixing part 53. Specifically, the fixing slot 50 penetrates the first surface and the second surface of the first fixing portion 331 along the Y-axis direction, and penetrates a surface of the first fixing portion 331 toward the negative Z-axis direction. The first fixing portion 331 is provided with a stopper 51. The first fixing portion 331 is provided with a plurality of mounting holes 55, openings of the plurality of mounting holes 55 of the first fixing portion 331 are located on a surface of the first fixing portion 331 toward the negative Z-axis direction, and are located on both sides of the fixing slot 50 along the X-axis direction.

The second fixing portion 332 is provided with a plurality of mounting holes 56, and the plurality of mounting holes 56 of the second fixing portion 332 penetrate the second fixing portion 332 along a thickness direction of the second fixing portion 332. Fasteners such as screws 333 may sequentially pass through the mounting holes 56 of the second fixing portion 332 and the mounting holes 55 of the first fixing portion 331, and be fixed to inner walls of the mounting holes 55 of the first fixing portion 331, so that the second fixing portion 332 is covered on the first fixing portion 331 along the Z-axis direction and is fixedly connected to the first fixing portion 331.

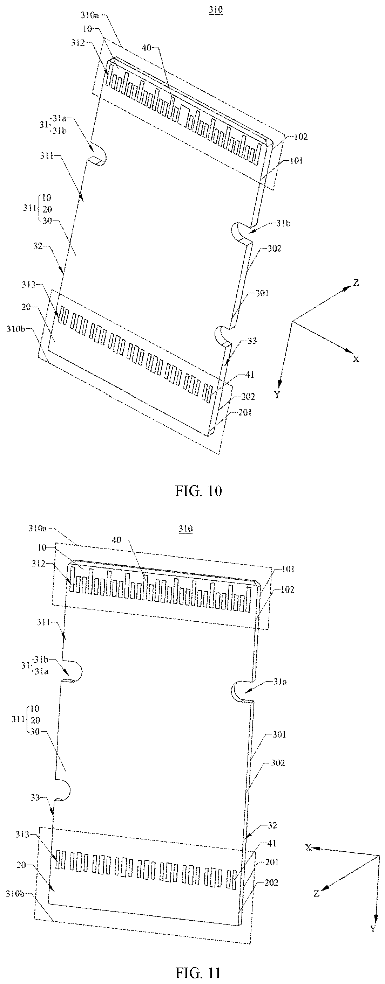

As shown in FIG. 10 and FIG. 11, FIG. 10 is a structural diagram of a terminal connecting member 310 in the backplane system 300 shown in FIG. 4, and FIG. 11 is a structural diagram of the terminal connecting member 310 shown in FIG. 10 from another perspective.

Each terminal connecting member 310 includes a circuit board 311, a first terminal group 312, and a second terminal group 313. The first terminal group 312 and the second terminal group 313 are disposed on a surface of the circuit board 311 and spaced apart, and electrically connected to the circuit board 311 to achieve an electrical connection between the first terminal group 312 and the second terminal group 313. The first terminal group 312 in the terminal connecting member 310 is configured to be electrically connected to the electronic module 500 to achieve an electrical connection between the terminal connecting member 310 and the electronic module 500. The second terminal group 313 in the terminal connecting member 310 is configured to be electrically connected to second terminal groups 313 of other terminal connecting members 310 by a plurality of cables 320 to achieve an electrical connection among the plurality of terminal connecting members 310. In this way, the plurality of electronic modules 500 may be electrically connected to each other by the plurality of terminal connecting members 310, further enabling signal interaction among the plurality of electronic modules 500 through the backplane system 300.

Specifically, the circuit board 311 includes a first end portion 10 (dashed box portion), a second end portion 20 (dashed box portion), and a main body portion 30. The first end portion 10 and the second end portion 20 are spaced apart and disposed opposite to each other along the Y-axis direction, and the main body portion 30 is electrically connected between the first end portion 10 and the second end portion 20. In the embodiment, the first end portion 10 and the second end portion 20 each have a uniform thickness, that is, along the Z-axis direction, a thickness of the first end portion 10 is uniform, and a thickness of the second end portion 20 is uniform. The first end portion 10 includes a first mounting face 101 and a second mounting face 102, and the first mounting face 101 and the second mounting face 102 are disposed facing away from each other along a thickness direction of the first end portion 10. The second end portion 20 includes a first fixing face 201 and a second fixing face 202, and the first fixing face 201 and the second fixing face 202 are disposed facing away from each other along a thickness direction of the second end portion 20. The main body portion 30 includes a first surface 301, a second surface 302, a first end face 32, and a second end face 33. The first surface 301 and the second surface 302 are disposed facing away from each other along a thickness direction of the main body portion 30, and the first end face 32 and the second end face 33 are disposed facing away from each other along a width direction of the main body portion 30. The first surface 301 is connected between the first mounting face 101 and the first fixing face 201, and the second surface 302 is connected between the second mounting face 102 and the second fixing face 202.

The main body portion 30 is provided with a snap-fit slot 31. A shape of the snap-fit slot 31 is adapted to a shape of the stopper 51. Each snap-fit slot 31 is configured to snap-fit with a stopper 51 of the fixing member 330, thereby achieving a fixed connection between the main body portion 30 and the fixing member 330, and consequently achieving a fixed connection between the terminal connecting member 310 and the fixing member 330. Specifically, the snap-fit slot 31 penetrates the main body portion 30 along the thickness direction of the main body portion 30, and penetrates an edge of the main body portion 30. There may be a plurality of snap-fit slots 31. The plurality of snap-fit slots 31 include a first snap-fit slot 31a and a second snap-fit slot 31b. The first snap-fit slot 31a and the second snap-fit slot 31b are respectively provided at opposite ends of the main body portion 30. The main body portion 30 may achieve snap-fitting with the fixing member 330 from opposite ends, thereby enhancing connection firmness between the terminal connecting member 310 and the fixing member 330.

Specifically, an opening of the first snap-fit slot 31a is located on a first end face 32 of the main body portion 30. The first snap-fit slot 31a penetrates the first end face 32 and is configured to snap-fit with a first stopper of the stopper 51. Specifically, an opening of the second snap-fit slot 31b is located on a second end face 33 of the main body portion 30. The second snap-fit slot 31b penetrates the second end face 33 and is configured to snap-fit with a second stopper of the stopper 51. A quantity of the first snap-fit slots 31a may be different from that of the second snap-fit slots 31b, achieving a foolproof effect and ensuring a precise assembly between the terminal connecting member 310 and the fixing member 330. For example, there are one first snap-fit slot 31a and two second snap-fit slots 31b. In other embodiments, the first snap-fit slot 31a and the second snap-fit slot 31b may also have different shapes, achieving the foolproof effect.

The first terminal group 312 includes a plurality of first conductive terminals 40, and the first conductive terminals 40 are mounted on the first end portion 10 and spaced apart from each other. Specifically, the plurality of first conductive terminals 40 include a first face terminal group and a second face terminal group. The plurality of first conductive terminals 40 of the first face terminal group are mounted on a first mounting face 101 of the first end portion 10, and are all electrically connected to the first end portion 10. The plurality of first conductive terminals 40 of the second face terminal group are mounted on a second mounting face 102 of the first end portion 10, and are all electrically connected to the first end portion 10, thereby achieving an electrical connection between the first terminal group 312 and the circuit board 311. In other embodiments, the first terminal group 312 may also only include the first face terminal group, that is, the plurality of first conductive terminals 40 of the first terminal group 312 are all mounted on the first mounting face 101; or, the first terminal group 312 includes only the second face terminal group, that is, the plurality of first conductive terminals 40 of the first terminal group 312 are all mounted on the second mounting face 102. Compared with configuring the first conductive terminals 40 only on the first mounting face 101 or only on the second mounting face 102, the plurality of first conductive terminals 40 are respectively mounted on the first mounting face 101 and the second mounting face 102 in the embodiment, which increases a mounting density of the first conductive terminals 40 and enhances an outgoing line density of the first cables 320 connected to the first conductive terminals 40, thereby meeting a high outgoing line density requirement of a large and complex computing or communication system.

In the embodiment, the first face terminal group includes a row of first conductive terminals 40, and the row of first conductive terminals 40 includes a plurality of first conductive terminals 40 which are spaced apart along the X-axis direction. The second terminal group includes a row of first conductive terminals 40, and the row of first conductive terminals 40 includes a plurality of first conductive terminals 40 which are spaced apart along the X-axis direction. In other embodiments, a quantity of rows of the first conductive terminals 40 in the first face terminal group may also be different from a quantity of rows of the first conductive terminals 40 in the second face terminal group. For example, the first face terminal group includes one row of first conductive terminals 40, and the second face terminal group includes two rows of first conductive terminals 40. In each row of first conductive terminals 40 of the first face terminal group, the plurality of first conductive terminals 40 may be equidistantly spaced apart along the X-axis direction, or may be unequidistantly spaced apart, which are not limited in the embodiments of the present application. In each row of first conductive terminals 40 of the second face terminal group, the plurality of first conductive terminals 40 may be equidistantly spaced apart along the X-axis direction, or may be unequidistantly spaced apart, which are not limited in the embodiments of the present application.

In the embodiment, the plug-in end portion 310a includes a first terminal group 312 and a first end portion 10. The plurality of first conductive terminals 40 in the first terminal group 312 are configured to be electrically connected to the electronic module 500, to achieve an electrical connection between the first terminal group 312 and the electronic module 500, thereby achieving an electrical connection between the plug-in end portion 310a and the electronic module 500.

The second terminal group 313 includes a plurality of second conductive terminals 41, and the plurality of second conductive terminals 41 are mounted on the second end portion 20 and spaced apart from each other. Specifically, the plurality of second conductive terminals 41 include a third face terminal group and a fourth face terminal group. A plurality of second conductive terminals 41 of the second terminal group 313 are mounted on a first mounting face 201 of the second end portion 20, and are all electrically connected to the second end portion 20. A plurality of second conductive terminals 41 of the fourth face terminal group are mounted on a second mounting face 202 of the second end portion 20, and are all electrically connected to the second end portion 20, thereby achieving an electrical connection between the second terminal group 313 and the circuit board 311 and an electrical connection between the second terminal group 313 and the first terminal group 312. In the embodiment, a quantity of rows of the second conductive terminals 41 in the third face terminal group may be same as a quantity of rows of the first conductive terminals 40 in the first face terminal group, and a quantity of rows of the second conductive terminals 41 in the fourth face terminal group may be same as a quantity of rows of the first conductive terminals 40 in the second face terminal group. In other embodiments, the second terminal group 313 may also include only the third face terminal group, that is, the plurality of second conductive terminals 41 of the second terminal group 313 are all mounted on the first mounting face 201; or, the first terminal group 312 includes only the fourth face terminal group, that is, the plurality of second conductive terminals 41 of the second terminal group 313 are all mounted on the second mounting face 202.

In the embodiment, the third face terminal group includes one row of second conductive terminals 41, and the one row of second conductive terminals 41 includes a plurality of second conductive terminals 41, and the plurality of second conductive terminals 41 are spaced apart along the X-axis direction. The fourth face terminal group includes one row of second conductive terminals 41, and the one row of second conductive terminals 41 includes a plurality of second conductive terminals 41, and the plurality of second conductive terminals 41 are spaced apart along the X-axis direction. In other embodiments, a quantity of rows of the second conductive terminals 41 in the third face terminal group may also be different from a quantity of rows of the second conductive terminals 41 in the fourth face terminal group. For example, the third face terminal group includes one row of second conductive terminals 41, and the fourth face terminal group includes two rows of second conductive terminals 41. In each row of second conductive terminals 41 of the third face terminal group, the plurality of second conductive terminals 41 may be equidistantly spaced apart along the X-axis direction, or unequidistantly spaced apart, which are not limited in the embodiments of the present application. In each row of second conductive terminals 41 of the fourth face terminal group, the plurality of second conductive terminals 41 may be equidistantly spaced apart along the X-axis direction, or unequidistantly spaced apart, which are not limited in the present application.

In the embodiment, the connecting end portion 310b includes a second terminal group 313 and a second end portion 20. The plurality of second conductive terminals 41 in the second terminal group 313 are configured for an electrical connection with the first cable 320, so that the first cable 320 is electrically connected among the plurality of second terminal groups 313, and the first cable 320 is electrically connected among connecting end portions 310b of the plurality of terminal connecting members 310.

In combination with FIG. 4, in an assembled backplane system 300, a plurality of connecting members 330 are respectively mounted in a plurality of mounting slots 60 of the cable box 340. A fixing part 53 of each fixing member 330 abuts against a surface of a carrying member 63 toward the mounting slot 60, and protrudes relative to a surface where the opening of the mounting slot 60 is located. The plurality of terminal connecting members 310 are respectively mounted in mounting slots 50 of the plurality of fixing members 330. A plug-in end portion 310a of each terminal connecting member 310 protrudes relative to a first surface 330a of the fixing member 330, and the connecting end portion 310b of each terminal connecting member 310 is accommodated in the accommodating cavity of the cable box 340. The plurality of first cables 320 are respectively electrically connected among the connecting end portions 310b of the plurality of terminal connecting members 310, and are accommodated in the accommodation cavity of the cable box 340.

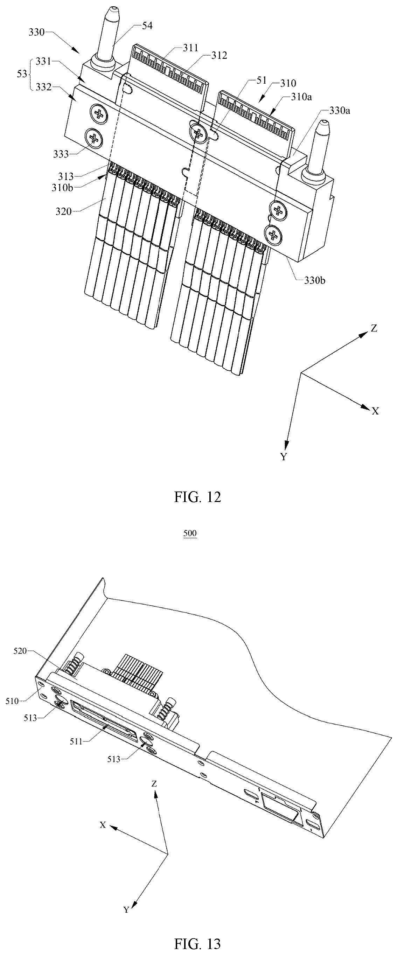

As shown in FIG. 12, FIG. 12 is a schematic diagram of an assembly structure of a terminal connecting member 310, a first cable 320 and a fixing member 330 in the backplane system 300 shown in FIG. 4.

When the backplane system 300 is assembled, the terminal connecting member 310, the first cable 320, and the fixing member 330 are assembled first. A first snap-fit slot 31a of the circuit board 311 in the terminal connecting member 310 (as shown in FIG. 10) is snap-fitted with a first stopper of the first fixing portion 331, and a second snap-fit slot 31b is snap-fitted with a second stopper to achieve snap-fitting between the snap-fit slot 31 and the stopper 51. The second fixing portion 332 is covered on the first fixing portion 331 along the Z-axis direction to enclose a fixing slot 50, and the first fixing portion 331 and the second fixing portion 332 are fixedly connected by fasteners such as screws 333, and assembled to form a fixing member 330, and the terminal connecting member 310 is mounted into the fixing slot 50 of the fixing member 330.

In this case, the plug-in end portion 310a of the terminal connecting member 310 protrudes relative to a first surface 330a of the fixing part 53, and the connecting end portion 310b protrudes relative to a second surface 330b of the fixing part 53. In addition, the guide portion 54 is located on a side of the fixing member 330 toward the plug-in end portion 310a. The snap-fit slot 31 and the stopper 51 are snap-fitted, which prevents the terminal connecting member 310 from falling off along the Y-axis direction. The first fixing portion 331 and the second fixing portion 332 are covered along the Z-axis direction, which prevents the terminal connecting member 310 from falling off along the Z-axis direction. The plurality of first cables 320 are respectively electrically connected to the plurality of second conductive terminals 41 of the second terminal group 313 in the connecting end portion 310b, so that the plurality of first cables 320 are electrically connected among the connecting end portions 310b of the plurality of terminal connecting members 310.

Then, the assembly structure shown in FIG. 12 and the cable box 340 are assembled. Specifically, the fixing part 53 of the fixing member 330 is mounted into the mounting slot 60 of the cover body 341 in the cable box 340 (see FIG. 7), the connecting end portions 310b of the plurality of terminal connecting members 310 and the plurality of first cables 320 are placed inside the box body 342, and the box body 342 is covered on the cover body 341 to form the cable box 340. The second surface 330b of the fixing part 53 abuts against a surface of the carrying member 63 (see FIG. 8) toward the mounting slot 60, and the first surface 330a of the fixing part 53 protrudes relative to the cable box 340. The connecting end portions 310b of the plurality of terminal connecting members 310 and the plurality of first cables 320 are accommodated in the accommodating cavity of the cable box 340.

In the backplane system 300 provided in the embodiments of the present application, the first cable 320 is used to be electrically connected among the second conductive terminals 41 of the plurality of terminal connecting members 310, to achieve an electrical connection among the plurality of terminal connecting members 310. Meanwhile, the first conductive terminals 40 of the plurality of terminal connecting members 310 are respectively electrically connected to the plurality of electronic modules 500, to achieve an electrical connection between the backplane system 300 and the plurality of electronic modules 500, thereby enabling signal interaction among the plurality of electronic modules 500 through the backplane system. In the backplane system 300 provided in the embodiments of the present application, the terminal connecting member 310 is electrically connected to the electronic module 500, which saves a connector mounted on a conventional backplane system, reduces a quantity of connectors used, and is conducive to reducing a signal transmission loss, thereby improving a signal bandwidth interconnected between the electronic modules 500.

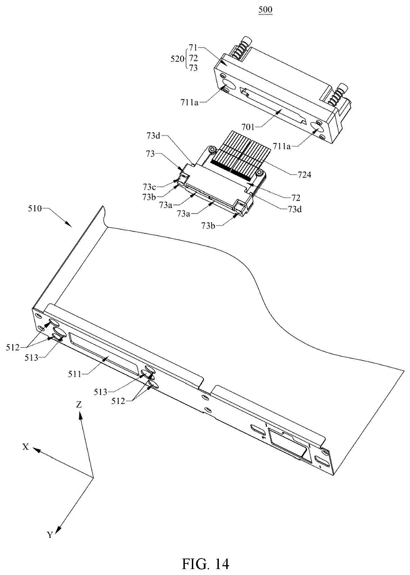

As shown in FIG. 13 and FIG. 14, FIG. 13 is a partial structural diagram of the electronic module 500 in the electrical connection structure shown in FIG. 2, and FIG. 14 is an exploded view of the partial structure of the electronic module 500 shown in FIG. 13.

The electronic module 500 includes a housing 510, a plurality of electronic components (not shown in FIG. 13 and FIG. 14), and a connector assembly 520. The plurality of electronic components and the connector assembly 520 are all mounted inside the housing 510, and some of the plurality of electronic components are electrically connected to the connector assembly 520. For example, the plurality of electronic components include mainboards, drives, storage cards and the like.

Specifically, the housing 510 is provided with a through slot 511, a plurality of through holes 512, and a plurality of positioning holes 513. The through slot 511, the plurality of through holes 512, and the plurality of positioning holes 513 penetrate the housing 510 along a thickness direction of the housing 510. In the embodiment, the through slot 511, the plurality of through holes 512, and the plurality of positioning holes 513 are all provided in a rear panel of the electronic module 500, so that the electronic module 500 is mounted on the cabinet body 100 from the front (as shown in FIG. 1), and is electrically connected to the backplane system 300 (as shown in FIG. 1). The plurality of through holes 512 are spaced apart and disposed around the through slot 511. For example, there are four through holes 512. The plurality of positioning holes 513 are spaced apart and disposed around the through slot 511, and are spaced apart from the through holes 512. For example, there are two positioning holes 513. The two positioning holes 513 are respectively located on both sides of the through slot 511. The plurality of positioning holes 513 of each electronic module 500 are respectively configured for the plurality of positioning members of one group of positioning members 62 in the cable box 340 to be inserted therein, to guide the through slot 511 of the housing 510 to align with the plug-in end portion 310a of the terminal connecting member 310, so that the plug-in end portion 310a of the terminal connecting member 310 extends into the through slot 511 to be plugged into the connector assembly 520.

The connector assembly 520 is mounted inside the housing 510, and is disposed opposite to the through slot 511, and is movable relative to the through slot 511. Specifically, the connector assembly 520 includes a floating member 71 and a connector 72. The floating member 71 is mounted on an inner side surface of the housing 510, the connector 72 is mounted on the floating member 71 and may be exposed relative to the through slot 511, and may move relative to the through slot 511 along the negative Y-axis direction, so that the connector 72 moves relative to the housing 510 along a direction facing away from the backplane system 300. In the embodiment, the connector 72 is mounted inside the floating member 71. For example, the connector 72 is a card connector.

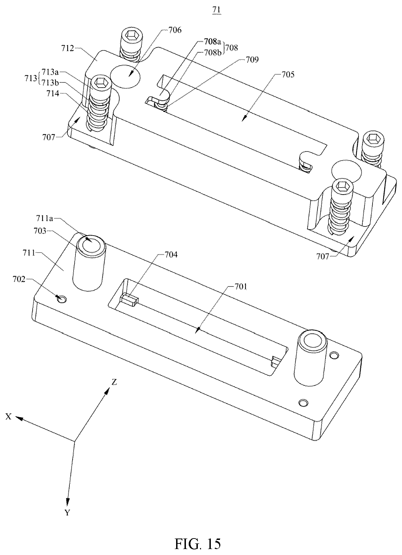

As shown in FIG. 15, FIG. 15 is an exploded structural diagram of a floating member 71 of a connector assembly 520 in the partial structure of the electronic module 500 shown in FIG. 14.

The floating member 71 includes a fixed base 711 and a floating base 712, where the floating base 712 is movable relative to the fixed base 711 along the Y-axis direction. Specifically, the fixed base 711 is provided with an avoidance slot 701 and a mounting hole 702. The avoidance slot 701 and the mounting hole 702 both penetrate the fixed base 711 along a thickness direction of the fixed base 711. In the embodiment, the fixed base 711 is generally rectangular, and the avoidance slot 701 is a rectangular slot. The avoidance slot 701 is located in the middle of the fixed base 711. The mounting hole 702 is located at an edge of the fixed base 711, and spaced apart from the avoidance slot 701. In the embodiment, there are four mounting slots 702, and the four mounting slots 702 are respectively located at four corners of the fixed base 711.

The floating base 712 is provided with a first mounting slot 705, a plurality of first fixing holes 706, a plurality of second mounting slots 707, and a plurality of second fixing holes, and the first mounting slot 705 and the plurality of first fixing holes 706 all penetrate the floating base 712 along a thickness direction of the floating base 712. The plurality of first fixing holes 706 are spaced apart and disposed around the first mounting slot 705. In the embodiment, the floating member 712 is generally rectangular. The first mounting slot 705 is a rectangular slot and located in the middle of the floating member 712. There are two first fixing holes 706, and the two first fixing holes 706 are located on both sides of the first mounting slot 705 along the X-axis direction and are spaced apart from the first mounting slot 705. Openings of the plurality of second mounting slots 707 are located on a surface of the floating base 712 facing away from the fixed base 711, and penetrate a circumferential side surface of the floating base 712. The second fixing hole is provided in a bottom wall of the second mounting slot 707, and penetrates the bottom wall of the second mounting slot 707 along a thickness direction of the bottom wall of the second mounting slot 707. In the embodiment, there are four second mounting slots 707, and the four second mounting slots 707 are spaced apart, and are located at four corners of the floating base 712. There are four second fixing holes, each provided at a bottom wall of one second mounting slot 707.

The floating base 712 is provided with a plurality of retaining parts 708, and the plurality of retaining parts 708 are spaced apart on a side wall of the first mounting slot 705. In the embodiment, there are two retaining parts 708, and the two retaining parts 708 are disposed on opposite side walls of the first mounting slot 705 along the X-axis direction. Specifically, each retaining part 708 includes a fixing portion 708a and a retaining portion 708b connected to the fixing portion 708a. The fixing portion 708a is fixedly connected to the side wall of the first mounting slot 705 and extends toward the first mounting slot 705. In the embodiment, the fixing portion 708a is flush with a surface of the floating base 712 facing away from the fixed base 711. The retaining portion 708b is protrudingly provided on a surface of the fixing portion 708a toward the fixed base 711, and extends toward the fixed base 711.

The floating member 71 further includes a plurality of guide posts 703, a plurality of carrying parts 704, an elastic member 709, a plurality of connecting parts 713, and a plurality of elastic parts 714. Specifically, the plurality of guide posts 703 are all mounted on a surface of the fixed base 711 toward the floating base 712, and all extend along a direction toward the floating base 712. The plurality of guide posts 703 are spaced apart and disposed around the avoidance slot 701. Each guide post 703 is in clearance fit with one first fixing hole 706, and is movable relative to the first fixing hole 706 along the Y-axis direction. For example, there are two guide posts 703, and the two guide posts 703 are spaced apart, and are located on both sides of the avoidance slot 701 along the X-axis direction.

The plurality of carrying parts 704 are provided on a side wall of the avoidance slot 701, and all extend toward the avoidance slot 701. The plurality of carrying parts 704 are configured to carry the connector 72. There is a height difference between a surface of the carrying part 704 toward the floating base 712 and the surface of the fixed base 711 toward the floating base 712. When the connector 72 is carried by the carrying part 704, the connector 72 is located in the avoidance slot 701, and the side wall of the avoidance slot 701 may prevent the connector 72 from shaking significantly in the avoidance slot 701, thereby enhancing stability of the connector 72 moving along the Y-axis direction. In the embodiment, there are four carrying parts 704, and the four carrying parts 704 are provided on side walls at four corners of the avoidance slot 701. An elastic member 709 is fixedly connected to the retaining portion 708 of the floating base 712, and is configured to be connected to the connector 72. The elastic member 709 may be compressed to drive the connector 72 to move along the negative Y-axis direction, and may exert thrust along the negative Y-axis direction on the floating base 712. Specifically, the elastic member 709 is sleeved on the retaining portion 708b of the retaining part 708 and abuts against the fixing portion 708a, achieving a fixed connection between the elastic member 709 and the retaining part 708, thereby achieving a fixed connection between the elastic member 709 and the floating base 712. In the embodiment, the elastic member 709 is a spring. There are two elastic members 709. Each of the two elastic members 709 is sleeved on a retaining portion 708b of each of the two retaining parts 708, and abuts against a fixing portion 708a of each of the two retaining parts 708.

Each connecting part 713 is in clearance fit with a second fixing hole in the floating base 712 and passes through the second fixing hole, and is fixedly connected to the fixed base 711. Specifically, each connecting part 713 includes a blocking portion 713a and an extension portion 713b. The blocking portion 713a is fixedly connected to the extension portion 713b, and protrudes relative to a circumferential side surface of the extension portion 713b. The extension portion 713b is in clearance fit with the second fixing hole to enable the connecting part 713 to move relative to the second fixing hole along the Y-axis direction. The extension portion 713b may pass through the second fixing hole and be fixedly connected to an inner wall of the mounting hole 702, thus achieving a fixed connection between the connecting part 713 and the fixed base 711. For example, the connecting part 713 is a bolt. In the embodiment, there are four connecting parts 713. The four connecting parts 713 are fixedly connected to inner walls of four second fixing holes in the bottom wall of the second mounting slot 707.

Each elastic part 714 is in a compressed state, and abuts against between one connecting part 713 and the floating base 712. Specifically, each elastic part 714 is sleeved on an outer side of the extension portion 713b, and abuts against between the blocking portion 713a and the bottom wall of the second mounting slot 707, so that the elastic part 714 abuts against between one connecting part 713 and the floating base 712. The floating base 712, under thrust along the negative Y-axis direction, may compress the elastic part 714, reducing spacing between the bottom wall of the second mounting slot 707 and the blocking portion 713a. The connecting part 713 is movable relative to the second fixing hole along the positive Y-axis direction, and the floating base 712 is movable relative to the fixed base 711 along the negative Y-axis direction, which increases deformation space of the elastic member 709, thus further increasing a range in which the connector 72 moves along the negative Y-axis direction. For example, the elastic part 714 is a spring. In the embodiment, there are four elastic parts 714, and each of the four elastic parts 714 is sleeved on an outer side of each of the four connecting parts 713.

The floating member 71 is further provided with a plurality of positioning holes 711a. Openings of the plurality of positioning holes 711a (in combination with FIG. 14) are located on a surface of the fixed base 711 facing away from the floating base 712, and each positioning hole 711a is configured for one positioning member of one group of positioning members 62 in the cable box 340 to be inserted therein. In the embodiment, the positioning hole 711a penetrates the fixed base 711 and the guide post 703 along a thickness direction of the floating member 71, increasing an insertion depth of the positioning member 62, thereby facilitating enhancing assembly stability of the positioning member 62 and the positioning hole 711a. In other embodiments, the positioning hole 711a may also only penetrate the fixed base 711, or not completely penetrate the fixed base 711.

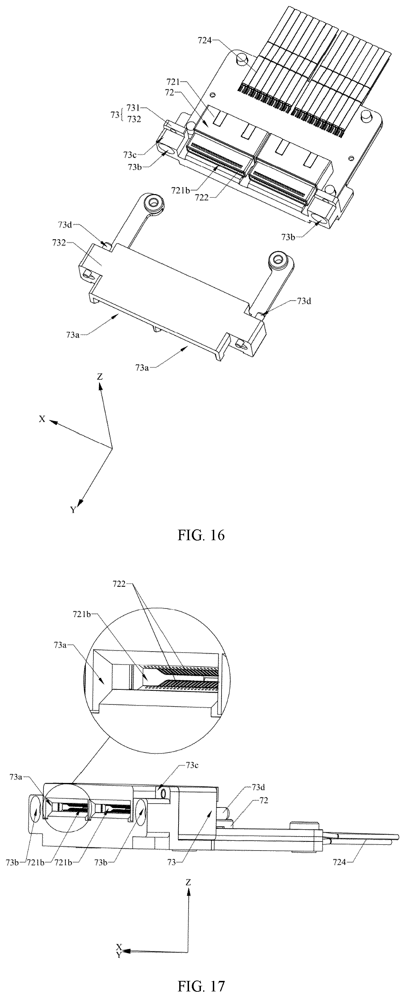

In combination with FIG. 14, FIG. 16 and FIG. 17, FIG. 16 is an exploded structural diagram of a connector 72 and a fixing housing 73 of a connector assembly 520 in the partial structure of the electronic module 500 shown in FIG. 14, and FIG. 17 is a schematic diagram of an assembly structure of the connector 72 and the fixing housing 73 shown in FIG. 16.

The connector 72 includes an outer housing 721, a first connecting end 722, and a second connecting end. The first connecting end 722 and the second connecting end are electrically connected, and both are mounted on the outer housing 721. The first connecting end 722 is configured to be electrically connected to the plug-in end portion 310a of the terminal connecting member 310 in the backplane system 300, and the second connecting end is configured to be electrically connected to an electronic component in the electronic module 500.

Specifically, the outer housing 721 is provided with a terminal slot 721b. An opening of the terminal slot 721b is located on a surface of the outer housing 721 toward the positive Y-axis direction. The terminal slot 721b includes a first side wall and a second side wall that are disposed opposite to each other along the Z-axis direction. The first connecting end 722 includes two connecting terminal groups, and each connecting terminal group includes a plurality of connecting terminals. The plurality of connecting terminals of the two connecting terminal groups of the first connecting end 722 are respectively embedded on the first side wall and the second side wall of the terminal slot 721b, and are spaced apart from each other, and respectively protrude toward the terminal slot 721b relative to the first side wall and the second side wall. The plurality of connecting terminals of the two connecting terminal groups of the first connecting end 722 are respectively configured to be electrically connected to a plurality of first conductive terminals 40 of the first face terminal group and the second face terminal group in the first terminal group 312, to achieve the electrical connection between the connector 72 and the terminal connecting member 310, thereby achieving an electrical connection between the electronic module 500 and the backplane system 300.

The second connecting end is electrically connected to an electronic component of the electronic module 500 such as a mainboard, to achieve the electrical connection between the connector 72 and the mainboard of the electronic module 500. In the embodiment, the second connecting end includes a plurality of connecting terminals, and the connector assembly 520 further includes a plurality of cables 724. The plurality of connecting terminals of the second connecting end are respectively electrically connected to the plurality of cables 724, and are respectively soldered to the mainboard by the plurality of cables 724, to achieve the electrical connection between the connector 72 and the mainboard of the electronic module 500. For example, the plurality of connecting terminals of the second connecting end are electrically connected to the plurality of cables by a circuit board. In other embodiments, the plurality of connecting terminals of the second connecting end may also be press-fitted into a press-fit hole in the mainboard to achieve an electrical connection between the connector 72 and the mainboard; alternatively, the second connecting end may also be electrically connected to the mainboard by a flexible printed circuit (Flexible Printed Circuit, FPC), to achieve an electrical connection between the connector 72 and the mainboard.

The connector assembly 520 further includes a fixing housing 73. The fixing housing 73 is mounted inside the floating member 71, and the connector 72 is mounted inside the fixing housing 73, so that the connector 72 is mounted inside the floating member 71. Specifically, the fixing housing 73 includes a first outer surface and a second outer surface that are disposed facing away from each other along the Y-axis direction. The first outer surface faces the positive Y-axis direction, and the second outer surface faces the negative Y-axis direction. In the embodiment, the first outer surface is approximately rectangular. The fixing housing 73 is provided with a plurality of mounting holes 73a, a plurality of guide holes 73b and a plurality of notch slots 73d. The plurality of mounting holes 73a penetrate the first outer surface and the second outer surface of the fixing housing 73 along the Y-axis direction. In the embodiment, there are two mounting holes 73a. The two mounting holes 73a are spaced apart along the X-axis direction. Each mounting hole 73a is configured for one connector 72 to be mounted therein. Openings of the plurality of guide holes 73b are all located on the first outer surface of the fixing housing 73, and are all recessed from the first outer surface toward the second outer surface. In the embodiment, there are two guide holes 73b, and the two guide holes 73b are spaced apart, and are located on both sides of the two mounting holes 73a along the X-axis direction. Openings of the plurality of notch slots 73d are all located on the first outer surface of the fixing housing 73, and are spaced apart from openings of the mounting holes 73a and the openings of the guide holes 73a. The notch slots 73d are recessed from the first outer surface toward the second outer surface, and penetrate a circumferential side surface of the fixing housing 73. In the embodiment, there are four notch slots 73d, and openings of the four notch slots 73d are located at four corners of the first outer surface. The fixing housing 73 is further provided with a protrusion portion 74d, and the protrusion portion 74d is provided on the second outer surface of the fixing housing 73 and extends along the negative Y-axis direction. In the embodiment, there are two protrusion portions 74d, and the two protrusion portions 74d are located on both sides of the second outer surface along the X-axis direction.

In the embodiment, the fixing housing 73 includes a first housing portion 731 and a second housing portion 732. The second housing portion 732 is covered on the first housing portion 731, and encloses a plurality of mounting holes 73a with the first housing portion 731. The first housing portion 731 is provided with a plurality of guide holes 73b and a plurality of notch slots 73d. The openings of the plurality of guide holes 73b are all located on the surface of the first housing portion 731 toward the positive Y-axis direction, and are recessed along the negative Y-axis direction. The openings of the plurality of notch slots 73d are all located on the surface of the first housing portion 731 toward the positive Y-axis direction, and are recessed along the negative Y-axis direction, and penetrate a circumferential side surface of the first housing portion 731. The second housing portion 732 is provided with a protrusion portion 74d, the protrusion portion 74d is disposed on a surface of the second housing portion 732 facing away from the first housing portion 731, and extends along a direction facing away from the first housing portion 731.

In an assembled electronic module 500, the fixed base 711 is mounted inside the housing 510, and the avoidance slot 701 is arranged opposite to the through slot 511. The floating base 712 is mounted on a side of the fixed base 711 facing away from the housing 510, and the first mounting slot 705 is arranged opposite to the avoidance slot 701 and the through slot 511. Each guide post 703 passes through one first fixing hole 706. The connector 72 is mounted into the mounting hole 73a of the fixing housing 73, and a first connecting end 722 of the connector 72 is located in the mounting hole 73a. The bottom walls of the plurality of notch slots 73d of the fixing housing 73 respectively abut against the plurality of carrying parts 704, so that the fixing housing 73 abuts against the carrying parts 704, and the mounting hole 73a is disposed opposite to the avoidance slot 701, so that the connector 72 passes through the avoidance slot 701 and the first mounting slot 705, and further the connector 72 is mounted inside the floating member 71 and exposed relative to the through slot 511. One end of the elastic member 709 is sleeved on the protrusion portion 74d of the fixing housing 73 and abuts against the second outer surface of the fixing housing 73, achieving a fixed connection between the elastic member 709 and the fixing housing 73, thereby achieving a fixed connection between the elastic member 709 and the connector 72. The other end of the elastic member 709 is sleeved on the retaining portion 708b of the retaining part 708 and abuts against the fixing portion 708a of the retaining part 708, so that the elastic member 709 is connected between the floating base 712 and the fixing housing 73, and the elastic member 709 is connected between the floating base 712 and the connector 72. The first outer surface of the fixing housing 73 is recessed relative to the surface of the fixed base 711 facing away from the guide post 703, so that the opening of the terminal slot 721b and the opening of the guide hole 73b are both located in the avoidance slot 701. This allows the connector 72 to be located inside the housing 510, which prevents the connector 72 from protruding relative to the housing 510, thereby enhancing appearance regularity of the electronic module 500. The plurality of connecting parts 713 respectively pass through the second fixing hole located in the bottom wall of the second mounting slot 707 and the mounting hole 702 of the fixed base 711, and are fixedly connected to the inner wall of the mounting hole 702, thus achieving a fixed connection between the plurality of connecting parts 713 and the fixed base 711. Each elastic part 714 abuts against and is connected between the connecting part 713 and the floating base 712. The floating base 712 is movable relative to the fixed base 711 and the connecting part 713 along the negative Y-axis direction, thereby compressing the elastic part 714.

Specifically, when the electronic module 500 is assembled, the connector 72 is mounted into the mounting hole 73a of the fixing housing 73, and the bottom walls of the plurality of notch slots 73d of the fixing housing 73 abut against the surface of the carrying part 704 in the fixed base 711 toward the floating base 712. The two guide posts 703 respectively extend into inner sides of two first fixing holes 706, to guide the floating base 712 to be mounted on a side of the fixed base 711 facing away from the housing 510 and to guide the avoidance slot 701 of the fixed base 711 to align with the first mounting slot 705 of the floating base 712 and disposed opposite to the first mounting slot 705. When the guide post 703 extends into the first fixing hole 706, one end of the elastic member 709 is sleeved on an outer side of the protrusion portion 74d of the fixing housing 73, and the other end is sleeved on the retaining portion 708b of the retaining part 708, so that the connector 72 passes through the avoidance slot 701 of the fixed base 711 and the first mounting slot 705 of the floating base 712, and further the connector 72 is mounted inside the floating member 71, and exposed relative to the avoidance slot 701. In this case, the first connecting end 722 of the connector 72 is located in the mounting hole 73a, and recessed relative to the avoidance slot 701, and the second connecting end protrudes relative to the floating base 712. In this case, the elastic member 709 may bend and deform relative to the avoidance slot 701 and the first mounting slot 705 in the X-Z plane, and may compress and deform along the Y-axis direction, so as to achieve floating of the connector 72 along the X-axis direction, Y-axis direction, and Z-axis direction.

The elastic part 714 is sleeved on an outer side of the extension portion 713b of the connecting part 713, and the extension portion 713b sequentially passes through the second mounting hole of the floating base 712, the mounting hole 702 of the fixed base 711 and the through hole 512 of the housing 510, and is fixed to an inner wall of the mounting hole 702 and an inner wall of the through hole 512, to achieve assembly of the connector assembly 520 and a fixed connection between the connector assembly 520 and the housing 510. In this case, the mounting hole 73a and the avoidance slot 701 are both arranged opposite to the through slot 511, the positioning hole 711a of the fixed base 711 is arranged opposite to the positioning hole 513 of the housing 510, the connector 72 is exposed relative to the through slot 511, and the elastic part 714 is in a compressed state to press the floating base 712 to the fixed base 711.

In combination with FIG. 6, when the electronic module 500 and the backplane system 300 are assembled, the positioning hole 513 of the housing 510 in each electronic module 500 and the positioning hole 711a of the fixed base 711 align with each group of positioning members 62 of the backplane system 300. The electronic module 500 is pushed along the positive Y-axis direction, so that each group of positioning members 62 aligns with and is sequentially inserted into a positioning hole 513 of a housing 510 in one electronic module 500 and the positioning hole 711a of the fixed base 711 to guide the through slot 511 of the housing 510 to align with the terminal connecting member 310. This facilitates guiding an electrical connection between the connector assembly 520 and the terminal connecting member 310, and in turn, facilitates guiding an electrical connection between the electronic module 500 and the backplane system 300.

When the electronic module 500 is pushed, the guide hole 73b of the fixing housing 73 in the connector assembly 520 aligns with the guide portion 54 of the fixing member 330 in the backplane system 300. The guide portion 54 aligns with and is inserted into the guide hole 73b of the fixing housing 73 in the connector assembly 520, to guide the plug-in end portion 310a of the terminal connecting member 310 to sequentially pass through the through slot 511, the avoidance slot 701 and the mounting hole 73a, and extend into and be plugged into the terminal slot 721b of the connector 72. The plurality of first conductive terminals 40 of the first face terminal group and the second face terminal group in the plug-in end portion 310a are electrically connected to the plurality of connecting terminals of two connecting terminal groups mounted in the terminal slot 721b, achieving an electrical connection between the plug-in end portion 310a and the first connecting end 722, thereby achieving an electrical connection between the terminal connecting member 310 and the connector assembly 520, and further achieving an electrical connection between the backplane system 300 and the electronic module 500.

When the plug-in end portion 310a of the terminal connecting member 310 is plugged into the terminal slot 721b of the connector 72, the terminal connecting member 310 exerts thrust along the negative Y-axis direction on the connector 72, and may push the connector 72 along the negative Y-axis direction and compress the elastic member 709. The elastic member 709 may be compressed and deformed, allowing the connector 72 to move relative to avoidance slot 701 and the first mounting slot 705 along the negative Y-axis direction. This effectively prevents the plug-in end portion 310a of the terminal connecting member 310 from being over-plugged into the terminal slot 721b of the connector 72, thereby achieving the anti-over-plugging effect. And, the elastic member 709 may further be bent and deformed relative to the avoidance slot 701 and the first mounting slot 705 in the X-Z plane, thereby achieving floating of the connector 72 along the X-axis direction, Y-axis direction, and Z-axis direction, and improving accuracy of a plug connection between the connector 72 and the terminal connecting member 310.

In addition, when the connector 72 compresses the elastic member 709, thrust along the negative Y-axis direction may be exerted to the floating base 712. The floating base 712 compresses the elastic part 714 under the thrust along the negative Y-axis direction, causing the elastic part 714 to be compressed and deformed. This allows the floating base 712 to move relative to the fixed base 711 along the negative Y-axis direction, so that the retaining part 708 of the floating base 712 may move along the negative Y-axis direction, which in turn drives the connector 72 to move along the negative Y-axis direction. Meanwhile, this increases deformation space of the elastic member 709, and further expands a range to which the connector 72 moves along the negative Y-axis direction, thereby further enhancing the anti-over-plugging effect.

In addition, after being compressed, the elastic part 714 may press the bottom wall of the second mounting slot 707 along the positive Y-axis direction, so that the floating base 712 may press the fixed base 711 along the positive Y-axis direction. After being compressed, the elastic member 709 may drive the connector 72 to move relative to the through slot 511 along the positive Y-axis direction, ensuring reliable touch between the first connecting end 722 of the connector 72 and the plug-in end portion 310a of the terminal connecting member 310. This ensures good electrical contact between the connector 72 and the terminal connecting member 310, thereby ensuring good electrical contact between the backplane system 300 and the electronic module 500.

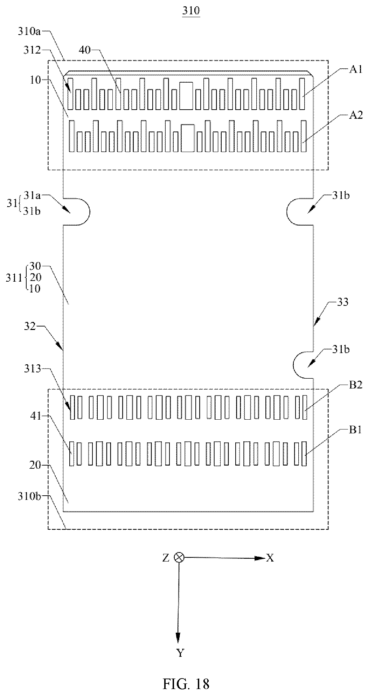

As shown in FIG. 18, FIG. 18 is a top view structural diagram of a terminal connecting member 310 according to a second embodiment of the present application.

A difference between the terminal connecting member 310 in the second embodiment and the terminal connecting member 310 in the first embodiment lies in that, in the terminal connecting member 310 of the second embodiment, the first face terminal group and the second face terminal group in the first terminal group 312 each includes two rows of first conductive terminals 40, and the third side terminal group and the fourth side terminal group in the second terminal group 313 each include two rows of second conductive terminals 41.

In the embodiment, a quantity, a quantity of rows, and arrangement of the plurality of first conductive terminals 40 in the first face terminal group are same as those of the plurality of first conductive terminals 40 in the second face terminal group. Quantity, row number, and arrangement of the plurality of second conductive terminals 41 in the third face terminal group are same as those of the plurality of second conductive terminals 41 in the fourth face terminal group. The following is illustrated by taking the first face terminal group and the third face terminal group for example. Specifically, along the positive Y-axis direction, two rows of first conductive terminals 40 in the first face terminal group of the first terminal group 312 are sequentially row A1 of first conductive terminals 40 and row A2 of first conductive terminals 40 which are spaced apart along the Y-axis direction. Along the negative Y-axis direction, two rows of second conductive terminals 41 in the third face terminal group of the second terminal group 313 are sequentially row B1 of second conductive terminals 41 and row B2 of second conductive terminals 41. The row B1 of second conductive terminals 41 and the row B2 of second conductive terminals 41 are spaced apart along the Y-axis direction. By via formation and layer transition in the circuit board 311 and through internal wiring, the row A1 of first conductive terminals 40 are electrically connected to the row B1 of second conductive terminals 41 and the row A2 of first conductive terminals 40 are electrically connected to the row B2 of second conductive terminals 41. This achieves an electrical connection between the first face terminal group of the first terminal group 312 and the third face terminal group of the second terminal group 313. At the same time, the electrical connection method also reduces via formation in the circuit board 311 and a quantity of layers required for circuit board wiring. In other embodiments, by via formation and layer transition in the circuit board 311 and through internal wiring, the row A1 of first conductive terminals 40 are electrically connected to the row B1 of second conductive terminals 41 and the row A2 of first conductive terminals 40 are electrically connected to the row B2 of second conductive terminals 41. This achieves an electrical connection between the first face terminal group of the first terminal group 312 and the third face terminal group of the second terminal group 313.

It is understandable that when a quantity of rows of the first conductive terminals 40 in the first face terminal group of the first terminal group 312 is ≥3, and the quantity of rows of the second conductive terminals 41 in the third face terminal group of the second terminal group 313 is ≥3, a plurality of rows of first conductive terminals 40 in the first face terminal group of the first terminal group 312 are spaced apart along the Y-axis direction, and a plurality of rows of second conductive terminals 41 in the third face terminal group of the second terminal group 313 are spaced apart along the Y-axis direction. Each row of first conductive terminals 40 in the first face terminal group of the first terminal group 312 may be electrically connected to each row of second conductive terminals 41 in the third face terminal group of the second terminal group 313 through via formation and layer transition in the circuit board 311. For example, the quantity of rows of the first conductive terminals 40 in the first face terminal group of the first terminal group 312 and the quantity of rows of the second conductive terminals 41 in the third face terminal group of the second terminal group 313 are both 3. Specifically, along the positive Y-axis direction, three rows of first conductive terminals 40 in the first face terminal group of the first terminal group 312 are sequentially the row A1 of first conductive terminals 40, the row A2 of first conductive terminals 40 and row A3 of first conductive terminals 40. Along the negative Y-axis direction, three rows of second conductive terminals 41 in the third face terminal group of the second terminal group 313 are sequentially the row B1 of second conductive terminals 41, the row B2 of second conductive terminals 41 and row B3 of second conductive terminals 41. By via formation and layer transition in the circuit board 311, and respectively through internal wiring, the row A1 of first conductive terminals 40 are electrically connected to the row B1 of second conductive terminals 41, the row A2 of first conductive terminals 40 are electrically connected to the row B2 of second conductive terminals 41 and the row A3 of first conductive terminals 40 are electrically connected to the row B3 of second conductive terminals 41. This achieves an electrical connection between the first terminal group 312 and the second terminal group 313. It is understandable that the first terminal group 312 may be electrically connected to the second terminal group 313 by other internal wiring methods, so that the row A1 of first conductive terminals 40 are electrically connected to the row B2 of second conductive terminals 41, the row A2 of first conductive terminals 40 are electrically connected to the row B1 of second conductive terminals 41, and the row A3 of first conductive terminals 40 are electrically connected to the row B3 of second conductive terminals 41.

As a node density of the computing nodes 501 in the electronic module 500 increases, more cabling wirings are required for an electrical connection therewith. In the terminal connecting member 310 of the backplane system 300 provided in embodiments of the present application, the first terminal group 312 is configured as a plurality of rows of first conductive terminals 40, and the second terminal group 313 is configured as a plurality of rows of second conductive terminals 41, so that the first terminal group 312 and the second terminal group 313 may be connected to more cables for wiring, which enhances a cable outgoing line density, adapts to outgoing line density requirements of different electronic modules 500, thereby solving the high outgoing line density requirement of the large and complex computing or communication system.

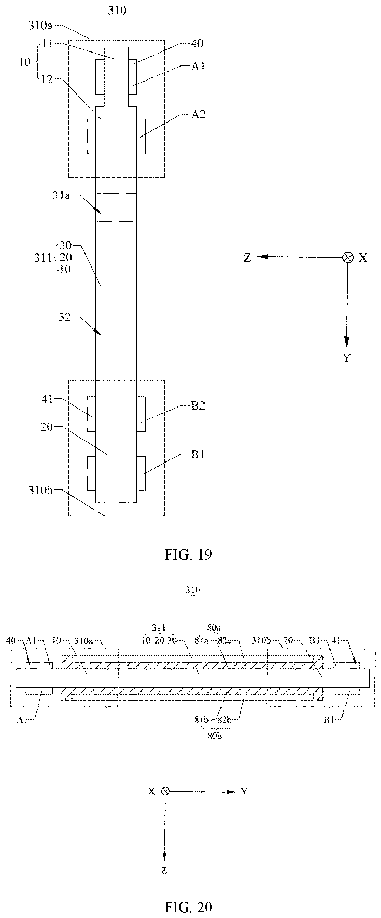

As shown in FIG. 19, FIG. 19 is a cross-sectional structural diagram of a terminal connecting member 310 according to a third embodiment of the present application.

A difference between the terminal connecting member 310 in the third embodiment and the terminal connecting member 310 in the second embodiment lies in that, in the terminal connecting member 310 of the third embodiment, the first end portion 10 of the circuit board 311 is not of uniform thickness, and a thickness of the first end portion 10 gradually decreases along a direction from the second end portion 20 to the first end portion 10.

Specifically, the first end portion 10 includes a plurality of mounting portions, which are sequentially arranged from the first end portion 10 toward the second end portion 20. In two adjacent mounting portions, a thickness of a mounting portion away from the second end portion 20 is less than a thickness of a mounting portion close to the second end portion 20. In the embodiment, along the direction from the first end 10 toward the second end 20, that is, along the negative Y-axis direction, the first end portion 10 sequentially includes a first mounting portion 11 and a second mounting portion 12, where the first mounting portion 11 is away from the second end 20, and the second mounting portion 12 is close to the second end portion 20. A thickness of the first mounting portion 11 is less than that of the second mounting portion 12. The A1 row of first conductive terminals 40 of the first terminal group 312 are located on the first mounting portion 11, and the A2 row of first conductive terminals 40 of the first terminal group 312 are located on the second mounting portion 12.

When the terminal connecting member 310 provided in the embodiment is processed, Overhang (suspended nickel or suspended gold) may occur on first conductive terminals 40 mounted on the end face close to the first end portion 10 (that is, first conductive terminals 40 mounted on the end face close to the circuit board 311 toward the negative Y-axis direction in the first terminal group 312, that is, the A1 row of first conductive terminals 40). When the plurality of first conductive terminals 40 of the terminal connecting member 310 are plugged into and mated with the connector 72 of the electronic module 500, due to a small mating gap between the terminal connecting member 310 and the connector 72, Overhang or detachment may occur on the first conductive terminals 40 of the first terminal group 312 during plug-in and plug-out of the terminal connecting member 310, thereby posing a short circuit risk between adjacent first conductive terminals 40 in the first terminal group 312. The thickness of the first end portion 10 is disposed, so that the plurality of rows of first conductive terminals 40 of the first terminal group 312 are staggered in height, which increases a mating gap between a first conductive terminal 40 on the end face close to the first end portion 10 in the first terminal group 312 (that is, a first conductive terminal 40 on an end face close to toward the negative Y-axis direction) and the connector 72. This avoids the problem of overhang or detachment caused by the plug-in and plug-out of the terminal connecting member 310, thereby solving the short circuit risk in the first conductive terminals 40 of the terminal connecting member 310.

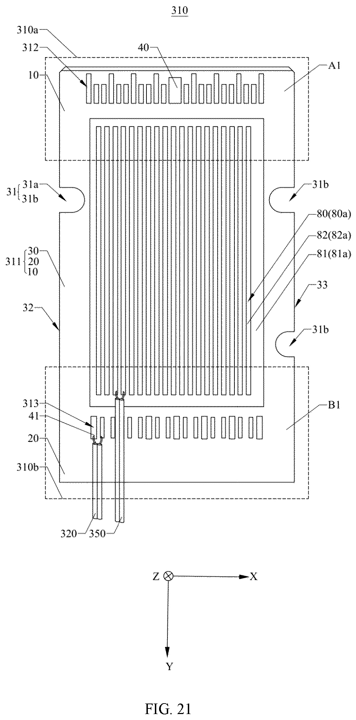

As shown in FIG. 20 and FIG. 21, FIG. 20 is a cross-sectional structural diagram of a terminal connecting member 310 according to a fourth embodiment of the present application, and FIG. 21 is a top view structural diagram of the terminal connecting member 310 shown in FIG. 20.

The terminal connecting member 310 in the fourth embodiment differs from the terminal connecting member 310 in the first embodiment in that the terminal connecting member 310 in the fourth embodiment further includes one first insert 80a and one second insert 80b. The first insert 80a and the second insert 80b are mounted on two surfaces of the circuit board 311 that are disposed facing away from each other along the Z-axis direction, and both cover part of the first end portion 10 and part of the second end portion 20. The first insert 80a is disposed between the A1 row of first conductive terminals 40 of the first face terminal group and the B1 row of second conductive terminals 41 of the third face terminal group. The second insert 80b is disposed between the A1 row of first conductive terminals 40 of the second face terminal group and the B1 row of second conductive terminals 41 of the fourth face terminal group.

Specifically, the first insert 80a includes a first carrier part 81a and a plurality of third conductive terminals 82a. The first carrier part 81a of the first insert 80a is mounted on a surface of the circuit board 311 toward the negative Z-axis direction, and cover part of the first end portion 10 and part of the second end portion 20. A plurality of third conductive terminals 82a are mounted on a surface of the first carrier part 81a that faces away from the circuit board 311, and are spaced apart along the X-axis direction. Each third conductive terminal 82a extends along the Y-axis direction, and extends from the first end portion 10 to the second end portion 20. Each third conductive terminal 82a includes a first end and a second end which are disposed facing away from each other along the Y-axis direction, the first end faces the first conductive terminal 40, and the second end faces the second conductive terminal 41. The first end portion 10, the A1 row of first conductive terminals 40 of the first face terminal group, the A1 row of first conductive terminals 40 of the second face terminal group, part of the first insert 80a located in the first end portion 10 and part of the second insert 80b located in the first end portion 10 form the plug-in end portion 310a.

The second insert 80b includes a second carrier part 81b and a plurality of fourth conductive terminals 82b. The second carrier part 81b of the second insert 80b are mounted on a surface of the circuit board 311 toward the positive Z-axis direction, and covers part of the first end portion 10 and part of the second end portion 20. A plurality of fourth conductive terminals 82b are mounted on a surface of the second carrier part 81b facing away from the circuit board 311, and are spaced apart along the X-axis direction. Each fourth conductive terminal 82b extends along the Y-axis direction, and extends from the first end portion 10 to the second end portion 20. Each fourth conductive terminal 82b includes a third end and a fourth end which are disposed facing away from each other along the Y-axis direction, the third end faces the first conductive terminal 40, and the fourth end faces the second conductive terminal 41. The second end portion 20, the B1 row of second conductive terminals 41 of the third face terminal group, the B1 row of second conductive terminals 41 of the fourth face terminal group, part of the first insert 80a located in the second end portion 20 and part of the second insert 80b located in the second end portion 20 form the connecting end portion 310b.

In the embodiment, the backplane system 300 further includes a plurality of second cables 350 and a plurality of third cables. The plurality of second cables 350 and the plurality of third cables are accommodated inside the cable box. Each second cable 350 is electrically connected between second ends of the third conductive terminals 82a of the two terminal connecting members 310, or, electrically connected between a second conductive terminal 41 of one terminal connecting member 310 and a second end of a third conductive terminal 82a in one terminal connecting member 310. Each third cable is electrically connected between fourth ends of fourth conductive terminals 82b of the two terminal connecting members 310, or, electrically connected between a second conductive terminal 41 of one terminal connecting member 310 and a fourth end of a fourth conductive terminal 82b in one terminal connecting member 310.

In the embodiment, the first insert 80a and the second insert 80b are disposed, so that the formed terminal connecting member 310 presents a three-dimensional structure. On one hand, the plurality of third conductive terminals 82a of the first insert 80a and the plurality of fourth conductive terminals 82b of the second insert 80b can ensure a mounting density of the conductive terminals, thereby ensuring a high cable outgoing line density. On the other hand, the first end and the second end of the third conductive terminal 82a are respectively electrically connected to the electronic module 500 and the second cable 350, and the third end and the fourth end of the fourth conductive terminal 82b are respectively electrically connected to the electronic module 500 and the third cable, achieving signal interaction among the plurality of electronic modules 500, without the need for via formation and layer transition in the circuit board 311, thereby saving a fabricating process.

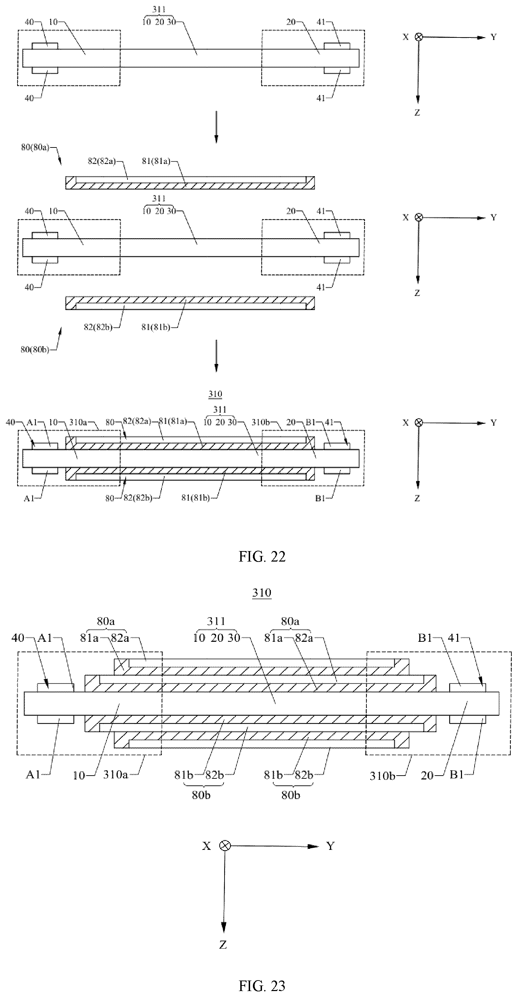

As shown in FIG. 22, FIG. 22 is a schematic diagram of a process flow of the terminal connecting member 310 shown in FIG. 20. Specifically, a fabricating process of the terminal connector 310 in the embodiment includes the following steps.

S1, take a circuit board 311, where the circuit board 311 includes a first end portion 10 and a second end portion 20 which are spaced apart from each other, fabricate a plurality of first conductive terminals 40 at the first end portion 10, and fabricate a plurality of second conductive terminals 41 at the second end portion 20. In the embodiment, the first end portion 10 and the second end portion 20 are disposed opposite to each other. A plurality of first conductive terminals 40 of the first face terminal group and a plurality of first conductive terminals 40 of the second face terminal group are respectively fabricated on two surfaces of the first end portion 10 that are disposed facing away from each other, and a plurality of second conductive terminals 41 of the third face terminal group and a plurality of second conductive terminals 41 of the fourth face terminal group are respectively fabricated on two surfaces of the second end portion 20 that are disposed facing away from each other. The third face terminal group is on a same side of the circuit board 311 as the first face terminal group, and the fourth face terminal group is on a same side of the circuit board 311 as the second face terminal group.

Step S2, fabricate an insert 80, where the insert 80 includes a carrier part 81 and a plurality of conductive terminals 82 mounted on a same side surface of the carrier part 81. In the embodiment, the insert 80 is fabricated by an in-mold injection molding process, and specifically, the insert 80 is obtained by placing a plurality of conductive terminals 82 at a bottom of a mold and then injection molding the material for the carrier part 81.

Step S3, mount at least one insert 80 between the plurality of first conductive terminals 40 and the plurality of second conductive terminals 41, where the carrier part 81 of the insert 80 faces the circuit board 311. In the embodiment, an insert 80 is mounted on a surface of the circuit board 311 and between the first face terminal group and the third face terminal group, where the carrier part 81 of the insert 80 faces the circuit board 311. The insert 80 mounted in step S3 forms a first insert 80a. In the embodiment, an insert 80 is mounted on the surface of the circuit board 311 and between the second face terminal group and the fourth face terminal group, where the carrier part 81 of the insert 80 faces the circuit board 311. The insert 80 mounted in step S4 forms the second insert 80b.

The sequences of step S1 and step S2 can be switched.

After the terminal connecting member 310 is fabricated, a plurality of first cables 320 are respectively soldered to a plurality of second conductive terminals 41 of the third face terminal group and a plurality of second conductive terminals 41 of the fourth face terminal group, and adhesive is applied to secure solder joints. Each of the plurality of second cables 350 is soldered to second ends of the plurality of third conductive terminals 82a in the first insert 80a of each of the two terminal connectors 310, and apply adhesive is applied to secure solder joints. Each of the plurality of third cables is soldered to fourth ends of the plurality of fourth conductive terminals 82b in the second insert 80b, and adhesive is applied to secure the solder joints, achieving an electrical connection between the terminal connecting member 310 and the plurality of first cables 320, the plurality of second cables 350, and the plurality of third cables.

As shown in FIG. 23, FIG. 23 is a cross-sectional structural diagram of a terminal connecting member 310 according to a fifth embodiment of the present application.

The terminal connecting member 310 in the fifth embodiment differs from the terminal connecting member 310 in the fourth embodiment in that the terminal connecting member 310 in the fifth embodiment further includes a plurality of first inserts 80a and a plurality of second insert 80b.

Specifically, there are a plurality of first inserts 80a in the terminal connecting member 310. The plurality of first inserts 80a are sequentially stacked and mounted on the surface of the circuit board 311 along the positive Z-axis direction. In each first insert 80a, the first carrier part 81a of the first insert 80a is close to the circuit board 311, and a plurality of third conductive terminals 82a of the first insert 80a are mounted on a surface of the first carrier part 81a facing away from the circuit board 311, and are spaced apart from each other. In two adjacent first inserts 80a, a first end and a second end of a third conductive terminal 82a in a first insert 80a close to the circuit board 311 are both exposed relative to the other first insert 80a, facilitating the first end and the second end of the third conductive terminal 82a of each first insert 80a to be respectively electrically connected to the electronic module 500 and the second cable 350.

There are a plurality of second inserts 80b, and the plurality of second inserts 80b are stacked and mounted on the surface of the circuit board 311 along the negative Z-axis direction. In each second insert 80b, the second carrier part 81b of the second insert 80b is close to the circuit board 311, and a plurality of fourth conductive terminals 82b of the second insert 80b are mounted on a surface of the second carrier part 81b facing away from the circuit board 311, and are spaced apart from each other. In two adjacent second inserts 80b, a third end and a fourth end along the Y-axis direction, of a fourth conductive terminal 82b in a second insert 80b close to the circuit board 311, are both exposed relative to the other second insert 80b, facilitating the third end and the fourth end of the fourth conductive terminal 82b of each second insert 80b to be respectively electrically connected to the electronic module 500 and the third cable.

In the embodiment, there are two first inserts 80a and two second inserts 80b. It is understandable that a quantity of first inserts 80a in the terminal connecting member 310 may be same as, or different from, a quantity of second inserts 80b. For example, there is one first insert 80a and two second inserts 80b, or there are two first inserts 80a and one second insert 80b. In some other embodiments, only the first insert 80a may be provided in the terminal connecting member 310, that is, a quantity of the first inserts 80a is zero, or only the second insert 80b may be provided, that is, a quantity of the second inserts 80b is zero.

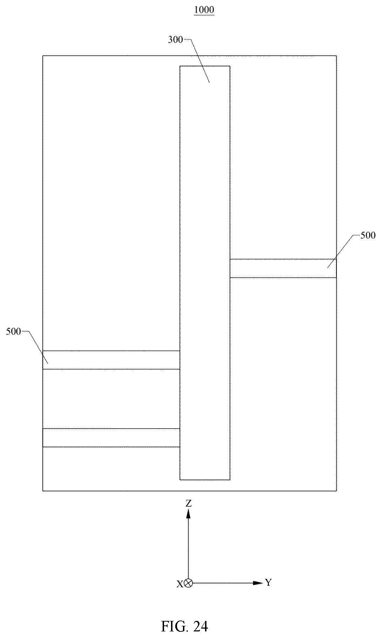

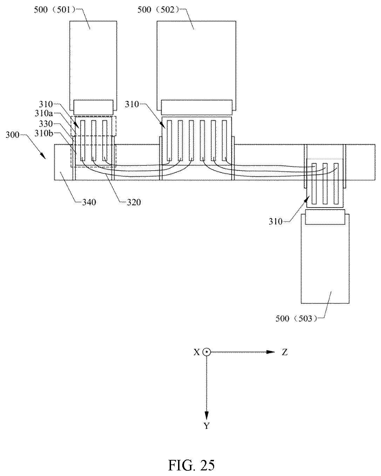

As shown in FIG. 24 and FIG. 25, FIG. 24 is a cross-sectional structural diagram of a cabinet 1000 according to a sixth embodiment of the present application, and FIG. 25 is a cross-sectional structural diagram of an electrical connection structure between a plurality of electronic modules 500 and a backplane system 300 in the cabinet 1000 shown in FIG. 24. It should be noted that in the electrical connection structure shown in FIG. 24, the plurality of electronic modules 500 are in a state before being plugged into the backplane system 300.

The cabinet 1000 in the sixth embodiment differs from the cabinet 1000 in the first embodiment in that, in the cabinet 1000 in the sixth embodiment, the plurality of terminal connecting members 310 in the backplane system 300 are located on different sides of the cable box 340, so that the plurality of electronic modules 500 are electrically connected to different sides of the backplane system 300.

Specifically, in the cabinet 1000 of the embodiment, the cable box 340 of the backplane system 300 is located in the middle of the cabinet body 100. Some of the plurality of terminal connecting members 310 of the backplane system 300 are mounted on a side of the cable box 340 toward the negative Y-axis direction, and are electrically connected to some of the plurality of electronic modules 500 to mount some of the electronic modules 500 on the side of the cable box 340 toward the negative Y-axis direction. Some of the plurality of terminal connecting members 310 are mounted on the side of the cable box 340 toward the negative Y-axis direction, and are electrically connected to some of the plurality of electronic modules 500, so that some of the electronic modules 500 are mounted on a side of the cable box 340 toward the positive Y-axis direction, thereby achieving the signal interaction among the plurality of electronic modules 500. For example, the computing node 501 and the switching module 502 are located on a side of the backplane system 300 toward the negative Y-axis direction, and a management module 503 is located on a side of the backplane system 300 toward the positive Y-axis direction. In the embodiment, the terminal connecting member 310 in the backplane system 300 may be any one of the terminal connecting members 310 in the first embodiment to the fifth embodiment.

The above disclosure represents merely preferred embodiments of the present application, and should not be construed as a limitation of the scope of the present application. Those skilled in the art can understand and implement all or part of the processes of the above embodiments, and any equivalent changes made based on claims of the present application still fall within the scope covered by the present application.

## Claims

1. A backplane system, wherein the backplane system is configured to be electrically connected to a plurality of electronic modules, and the backplane system comprises a cable box, a plurality of terminal connecting members, and a plurality of first cables, wherein the cable box is provided with an accommodating cavity, each terminal connecting member comprises a circuit board, a plurality of first conductive terminals and a plurality of second conductive terminals, the circuit board comprises a first end portion and a second end portion which are spaced apart from each other, the circuit board is mounted in the cable box, the first end portion protrudes relative to the cable box, the second end portion is located in the accommodating cavity, the plurality of first conductive terminals are mounted on the first end portion and spaced apart from each other, and are configured to be electrically connected to one of the electronic modules, the plurality of second conductive terminals are mounted on the second end portion and spaced apart from each other, the plurality of first conductive terminals are respectively electrically connected to the plurality of second conductive terminals, and each first cable is located in the accommodating cavity, and electrically connected between second conductive terminals of two terminal connecting members.

2. The backplane system according to claim 1, wherein the first end portion comprises a first mounting face and a second mounting face, the first mounting face and the second mounting face are disposed facing away from each other along a thickness direction of the first end portion, and the plurality of first conductive terminals are mounted on at least one of the first mounting face and the second mounting face.

3. The backplane system according to claim 2, wherein each terminal connecting member comprises a first face terminal group and a second face terminal group, the first face terminal group and the second face terminal group each comprises a plurality of first conductive terminals, the plurality of first conductive terminals of the first face terminal group are mounted on the first mounting face, and the plurality of first conductive terminals of the second face terminal group are mounted on the second mounting face.

4. The backplane system according to claim 3, wherein the first face terminal group comprises at least one row of first conductive terminals, and/or, the second face terminal group comprises at least one row of first conductive terminals; and
each row of first conductive terminals comprises a plurality of first conductive terminals.

5. The backplane system according to claim 4, wherein the first face terminal group comprises a plurality of rows of first conductive terminals;
the first end portion comprises a plurality of mounting portions, the plurality of mounting portions are sequentially arranged along a direction from the first end portion to the second end portion, among any two adjacent mounting portions, a thickness of a mounting portion away from the second end portion is less than a thickness of a mounting portion close to the second end portion, and the plurality of rows of first conductive terminals of the first face terminal group are respectively mounted on the plurality of mounting portions.

6. The backplane system according to claim 5, wherein the second face terminal group comprises a plurality of rows of first conductive terminals, and the plurality of rows of first conductive terminals of the second face terminal group are respectively mounted on the plurality of mounting portions.

7. The backplane system according to any one of claims 3 to 6, wherein the second end portion comprises a first fixing face and a second fixing face, the first fixing face and the second fixing face are disposed facing away from each other along a thickness direction of the second end portion, each terminal connecting member comprises a third face terminal group and a fourth face terminal group, the third face terminal group and the fourth face terminal group each comprise a plurality of second conductive terminals, the plurality of second conductive terminals of the third face terminal group are mounted on the first mounting face, and the plurality of second conductive terminals of the fourth face terminal group are mounted on the second mounting face.

8. The backplane system according to claim 7, wherein each terminal connecting member further comprises a first insert and a plurality of second cables, the first insert comprises a first carrier part and a plurality of third conductive terminals, the first carrier part is mounted on the circuit board and disposed between the first face terminal group and the third face terminal group, and the plurality of third conductive terminals are mounted on a surface of the first carrier part facing away from the circuit board, and are spaced apart from each other;
each third conductive terminal comprises a first end and a second end which are disposed facing away from each other, the first end faces the first conductive terminal, and is configured to be electrically connected to the electronic module, and the second end faces the second conductive terminal; and
each second cable is located in the accommodating cavity, and electrically connected between second ends of the two terminal connecting members, or, electrically connected between a second conductive terminal of one terminal connecting member and a second end of one terminal connecting member.

9. The backplane system according to claim 8, wherein there are a plurality of first inserts, and the plurality of first inserts are stacked and mounted on the circuit board.

10. The backplane system according to claim 9, wherein between any two adjacent first inserts, a first end and a second end of a first insert close to the circuit board are both exposed relative to the other first insert.

11. The backplane system according to any one of claims 8 to 10, wherein each terminal connecting member further comprises a second insert and a plurality of third cables, the second insert comprises a second carrier part and a plurality of fourth conductive terminals, the second carrier part is mounted on the circuit board and disposed between the second face terminal group and the fourth face terminal group, and the plurality of fourth conductive terminals are mounted on a surface of the second carrier part facing away from the circuit board, and are spaced apart from each other;
each fourth conductive terminal comprises a third end and a fourth end which are disposed facing away from each other, the third end faces the first conductive terminal, and is configured to be electrically connected to the electronic module, and the fourth end faces the second conductive terminal; and
each third cable is located in the accommodating cavity, and electrically connected between fourth ends of the two terminal connecting members, or, electrically connected between a second conductive terminal of one terminal connecting member and a fourth end of one terminal connecting member.

12. The backplane system according to claim 1, further comprising a plurality of fixing members, wherein the plurality of fixing members are mounted in the cable box, each fixing member is provided with at least one fixing slot, each fixing slot penetrates the fixing member along a width direction of the fixing member, a circuit board of each terminal connecting member is mounted in one fixing slot, and the first end portion and the second end portion both protrude relative to the fixing member.

13. The backplane system according to claim 12, wherein a stopper is provided on a side wall of each fixing slot, and a circuit board of each terminal connecting member comprises a main body portion, the main body portion is provided with a snap-fit slot, the snap-fit slot penetrates the main body portion along a thickness direction of the main body portion and penetrates an edge of the main body portion, the main body portion is mounted in the fixing slot, and the snap-fit slot snap-fits with the stopper.

14. The backplane system according to claim 13, wherein the stopper comprises a first stopper and a second stopper, the first stopper and the second stopper are respectively provided on two oppositely disposed side walls of the fixing slot, the snap-fit slot comprises a first snap-fit slot and a second snap-fit slot, the first snap-fit slot and the second snap-fit slot are respectively provided at opposite ends of the main body portion, the first snap-fit slot snap-fits with the first stopper, the second snap-fit slot snap-fits with the second stopper, and a quantity of the first snap-fit slots is different from a quantity of the second snap-fit slots.

15. The backplane system according to claim 12, wherein each fixing member comprises a fixing part and a plurality of guide parts, the fixing part is provided with the fixing slot, the fixing slot penetrates the fixing part along a width direction of the fixing part, and the plurality of guide parts are all mounted on a surface of the fixing part toward the first end portion, all extend along a direction facing away from the fixing part, and are disposed around the fixing slot.

16. The backplane system according to claim 1, wherein further comprising a plurality of groups of positioning members, each group of positioning members comprises a plurality of positioning members, the plurality of positioning members are all mounted on a surface of the cable box facing away from the accommodating cavity, all extend along a direction facing away from the accommodating cavity, and are disposed around the terminal connecting member, and the plurality of positioning members of each group of positioning members are configured to position one of the electronic modules.

17. A cabinet, comprising a cabinet body, a plurality of electronic modules, and the backplane system according to any one of claims 1 to 16, wherein the plurality of electronic modules and the backplane system are all mounted inside the cabinet body, and each of the plurality of electronic modules is electrically connected to the plurality of first conductive terminals of the terminal connecting member.

18. The cabinet according to claim 17, wherein each electronic module comprises a housing, at least one connector and a plurality of electronic components, the at least one connector is mounted inside the housing, the housing is provided with at least one through slot, the at least one through slot penetrates the housing along a thickness direction of the housing, each connector is exposed relative to the through slot, and is electrically connected to the plurality of first conductive terminals of the terminal connecting member.

19. The cabinet according to claim 18, wherein each electronic module further comprises at least one floating member, the at least one floating member is mounted inside the housing, and each connector is mounted on one floating member and movable relative to the housing along a direction facing away from the backplane system.

20. The cabinet according to claim 17, wherein some of the terminal connecting members are mounted on one side of the cable box, some of the terminal connecting members are mounted on another side of the cable box, some of the electronic modules are located on one side of the cable box, and some of the electronic modules are located on another side of the cable box.

21. A fabrication method for a backplane system, comprising steps of fabricating a terminal connecting member, wherein the steps comprise:
obtaining a circuit board, wherein the circuit board comprises a first end portion and a second end portion which are spaced apart from each other, fabricating a plurality of first conductive terminals at the first end portion, and fabricating a plurality of second conductive terminals at the second end portion;
fabricating an insert, wherein the insert comprises a carrier part and a plurality of conductive terminals, and the plurality of conductive terminals are mounted on a same side surface of the carrier part; and
mounting at least one insert between the plurality of first conductive terminals and the plurality of second conductive terminals, wherein the carrier part of the insert faces the circuit board.

22. The fabrication method for the backplane system according to claim 21, wherein the plurality of first conductive terminals comprise a first face terminal group and a second face terminal group, a plurality of first conductive terminals of the first face terminal group and a plurality of first conductive terminals of the second face terminal group are respectively mounted on two surfaces of the first end portion which are disposed facing away from each other, the plurality of second conductive terminals comprise a third face terminal group and a fourth face terminal group, a plurality of second conductive terminals of the third face terminal group and a plurality of second conductive terminals of the fourth face terminal group are respectively mounted on two surfaces of the second end portion which are disposed facing away from each other, and the third face terminal group and the first face terminal group are located on a same side of the circuit board, and the fourth face terminal group and the second face terminal group are located on a same side of the circuit board; and
there are a plurality of inserts, at least one of the plurality of inserts is mounted on the circuit board, and located between the first face terminal group and the third face terminal group, and at least one of the plurality of inserts is mounted on the circuit board, and located between the second face terminal group and the fourth face terminal group.
